(19) Europäisches Patentamt
European Patent Office
Office européen des brevets

(11) **EP 2 063 279 B1**

(12) **EUROPEAN PATENT SPECIFICATION**

(45) Date of publication and mention
of the grant of the patent:
**17.04.2013 Bulletin 2013/16**

(51) Int Cl.:
***G01R 19/165*** *(2006.01)*   ***G01R 31/36*** *(2006.01)*

(21) Application number: **08169628.8**

(22) Date of filing: **21.11.2008**

(54) **Voltage detecting device for battery modules**

Spannungserkennungsvorrichtung für Batteriemodule

Dispositif de détection de la tension pour modules de batterie

(84) Designated Contracting States:
**DE FR GB**

(30) Priority: **26.11.2007 JP 2007303915**
**26.11.2007 JP 2007303918**
**24.09.2008 JP 2008244594**

(43) Date of publication of application:
**27.05.2009 Bulletin 2009/22**

(73) Proprietor: **HONDA MOTOR CO., LTD.**
**Minato-ku**
**Tokyo**
**107-8556 (JP)**

(72) Inventor: **Ohnuki, Yasumichi**
**Saitama 351-0193 (JP)**

(74) Representative: **Rupp, Christian et al**
**Mitscherlich & Partner**
**Patent- und Rechtsanwälte**
**Sonnenstrasse 33**
**80331 München (DE)**

(56) References cited:
**EP-A- 1 391 962    JP-A- 2005 003 618**
**US-B2- 6 803 766**

**Description**

Background of the Invention

Field of the Invention

The present invention relates to a voltage detecting device for battery modules to detect the voltage of each battery module of a secondary battery.

Description of the Related Art

For example, an electric power for an electric vehicle and a hybrid vehicle is supplied from a secondary battery comprised of a number of cells connected in series. Accordingly, the voltage of a battery module which is a series circuit of a plurality of cells is normally monitored.

According to a method of detecting the voltage of the battery module of the secondary battery, there is known a measuring method by which an output voltage of the battery module to be measured is applied to one capacitor by sequentially switching switches, so that the capacitor is charged, and a voltage across the capacitor is measured by a differential amplifier.

When an A/D (analog to digital) converter converts an analog output signal of the differential amplifier into a digital signal, aliasing occurs due to noise caused by frequencies higher than half a sampling frequency. Preferably, an anti-aliasing filter is applied between the switch and a battery module to be measured so as to prevent the aliasing.

JP2005-003618A discloses a voltage detecting circuit which includes an anti-aliasing filter for each battery module. The anti-aliasing filter is a low-pass filter composed of a resistor and a capacitor.

However, the technology disclosed in JP2005-003618A has the problem in occurring the difference in frequency response between the battery modules and having an inhomogeneous filter characteristic with respect to each battery module since a resistor connected between the battery modules is commonly used. In other words, when two sets of resistors are provided for each battery module, the frequency response is equalized. However, when the resistor between the battery modules is commonly provided in order to reduce the number of electronic parts, the frequency response becomes inhomogeneous. In this case, even if there is no difference in an output voltage waveform of each battery module, there appears the difference in the voltage waveform of each battery module through a filter. Accordingly, it is erroneously determined that the battery module is in an irregular condition. In particular, since the voltage detecting circuit of JP2005-003618A amends the difference in frequency response between the battery modules on the basis of a constant value of electronic parts, the constant value needs to be strictly determined. If the constant value is erroneously determined, an error resulting from variance of the constant value is considerably large. For example, if a photo MOS relay having a predetermined delay time in switching is provided for a switch, a sampling frequency of switching cannot be raised due to a long delay time. Consequently, the voltage detecting device including the photo MOS relay is affected by the noise of a relatively low frequency.

U.S. Patent No. 6,803,766 discloses that a battery cell voltages are read in parallel to a capacitor for each battery block of a battery pack by the use of analog switches. The stored voltages of the capacitors are A/D-converted sequentially through the analog switches. Thereby, each cell voltage is measured with suppression of measurement error by the use of the simple flying capacitor type circuit structure, while the circuit safety is secured by providing the current limitation resistor having a large resistance value between each cell and the analog switch. A noise reduction circuit having a pair of capacitors is provided.

Brief Summary of the Invention

An aspect of the present invention according to claim 1 provides a voltage detecting device for battery modules for reducing a difference in frequency response of battery module whose voltage is detected.

According to the voltage detecting device for battery modules, when the number of battery modules is "M" being a positive and uneven integer and "N" is a positive integer, the resistor/capacitor configuration is made up of (M+1) sets of resistors having an equal resistance value to connect an N-th input terminal of the filter circuit to an N-th output terminal of the filter circuit, and (M+1)/2 sets of capacitors having equal capacitance and connected to the output terminals of N-th and (M+2-N)-th resistors out of the (M+1) sets of resistors.

According to the voltage detecting device for battery modules, when the number of battery modules is "M" being a positive and even integer and "N" is a positive integer, the resistor/capacitor configuration is made up of a resistor having an arbitrary resistance value, including a zero ohm resistor, to connect M/2-th input terminal of the filter circuit to M/2-th output terminal of the filter circuit, M sets of resistors having an equal resistance value to connect an N-th input terminal of the filter circuit to an N-th output terminal of the filter circuit, apart from M/2-th input terminal of the filter circuit, and M/2 sets of capacitors having equal capacitance and connected between the output terminals of N-th and (M+2-N)-th resistors out of (M+1) sets of resistors.

According to the voltage detecting device for battery modules, when "M", "P", and "Q" are a positive integer, "P" is less than half of "M", and "Q" is not equal to "P" and less half of "M", and a capacitor connected between P-th and (M+2-P)-th resistors and a capacitor between Q-th and (M+2-Q)-th resistors are replaced with a capacitor connected between the Q-th and P-th resistors, a capacitor connected between the P-th and (M+2-Q)-th resistors, a capacitor connected between the Q-th and (M+2-P)-th resistors, and a capacitor connected between the (M+2-Q)-th and (M+2-P)-th resistors, and all the capacitors have approximately equal capacitance.

According to the voltage detecting device for battery modules, "M" is a positive integer, and a resistor connected between M/2-th input terminal of the filter circuit and M/2-th output terminal of the filter circuit is replaced with a wire.

According to the voltage detecting device for battery modules, when the number of battery module is expressed as "M" being a positive and integer, a resistor connected between M/2-th input terminal of the filter circuit and M/2-th output terminal of the filter circuit is replaced with a wire.

According to the voltage detecting device for battery modules, the resistor is provided as a dummy load by a switching capacitor method of providing the capacitor and a plurality of switches.

According to the voltage detecting device for battery modules, the switching circuit is an analog multiplexer integrally and separately constituted with the voltage detecting circuit.

A first voltage detecting device for battery modules individually detects a voltage of the battery module of the secondary battery 11 which includes M (a positive integer) sets of battery modules composed of at least one cell or more and connected in series. The first voltage detecting device for battery modules includes a plurality of switches 14 connected to both terminals of each battery module, resistors having an equal resistance value and connected in series between both terminals of each battery module and the switches, filters 12 composed of the resistors and capacitors having equal capacitance. When the number M of battery modules is an even number, the resistor connected to the terminals of the battery modules disposed at the center of a circuit can have an arbitrary resistance value. The capacitors are respectively connected in parallel with the battery module and connected to contact points which are disposed between the resistors and the switches. The capacitors constituting the filter provide a first capacitor group and a second capacitor group, which is disposed in parallel with the first capacitor group. The first capacitor group and the second capacitor group are symmetrically disposed on a positive terminal side and a negative terminal side of the secondary battery whose center is a fold-back point, so that the circuit including the first capacitor group and the second capacitor group can provide an approximately equal frequency response with respect to each battery module to be measured.

When the number M of battery modules of the first voltage detecting device for battery modules is three, a second voltage detecting device for battery modules includes a circuit having the secondary battery and the filter. The circuit comprises three sets of battery modules connected in series, four sets of resistors (for example, R31, R32, R33, and R34) having an equal resistance value and, two sets of end capacitors (for example, C31 and C34) having the equal capacitance, a negative-electrode-side peripheral capacitor (for example, C32) having the equal capacitance, and a positive-electrode-side peripheral capacitor (for example, C33) having the equal capacitance.

The resistors R31, R32, R33, and R34 are connected in series between the switches and both terminals of each battery module. The end capacitors C31 and C34 are connected between contact points which are disposed between the switches and the resistors R31, R32, R33, and R34. The resistors R31, R32, R33, and R34 are connected to both terminals of end battery modules out of the three battery modules connected in series. The negative-electrode-side peripheral capacitor C32 is connected between contact points which are disposed between the switches and the resistors R31 and R34. The resistors R31 and R34 are connected to a negative-electrode terminal of the top battery module out of the three battery modules connected in series and a negative-electrode terminal of the end battery module out of the three battery modules connected in series. The positive-electrode-side peripheral capacitor C33 is connected between contact points which are disposed between the switches and the resistors R31 and R33. The resistors R31 and R33 are connected to a positive-electrode terminal of the end battery module out of the three battery modules connected in series and a positive-electrode terminal of the top battery module out of the three battery modules connected in series.

When the number M of battery modules of the first voltage detecting device for battery modules is 4n (n is a positive integer), a third voltage detecting device for battery modules includes a circuit having a secondary battery and a filter. The circuit comprises the four-battery-module-type battery unit having N sets of filters sequentially being nested at the fold-back point.

When the number M of battery modules of the first voltage detecting device for battery modules is (4n+1) (n is a positive integer), a fourth voltage detecting device for battery modules includes a circuit having the secondary battery and the filter. The circuit comprise the four-battery-module-type battery unit having N sets of filters sequentially being nested at the fold-back point, and the one-battery-module-type battery unit disposed between the second and third battery modules of the four-battery-module-type battery unit disposed at the fold-back point.

When the number M of battery modules of the first voltage detecting device for battery modules is (4n+2) (n is a positive integer), a fifth voltage detecting device for battery modules includes a circuit having the secondary battery and the filter. The circuit comprises the four-battery-module-type battery unit having N sets of filters sequentially being nesting at the fold-back point, and the two-battery-module-type battery unit disposed between the second and third battery modules of the four-battery-module-type battery unit disposed at the fold-back point.

When the number M of battery modules of the first voltage detecting device for battery modules is (4n+3) (n is a positive integer), a sixth voltage detecting device for battery modules includes a circuit having the secondary battery and the filter. The circuit comprises the four-battery-module-type battery unit N sets of filters sequentially being nested at the fold-back point, and the three-battery-module-type battery unit disposed between the second and third battery modules of the four-battery-module-type battery unit disposed at the fold-back point.

A seventh voltage detecting device for battery modules is based on the fourth voltage detecting device for battery modules, and includes the one-battery-module-type battery unit whose circuit is composed of a set of battery module and one-battery-module filter block which includes two sets of resistors having the equal resistance value and capacitors having the equal capacitance. The two sets of resistors are disposed in series between the switches and both terminals of the battery module. The capacitor are connected between contact points which are disposed between the switches and the resistors connected to both terminals of the battery module.

An eighth voltage detecting device for battery modules is based on the fifth voltage detecting device for battery modules, and includes two sets of battery modules connected in series and the two-battery-module-type battery unit whose circuit is composed of two-battery-module filter block which includes two sets of resistors having the equal resistance value and capacitors having the equal capacitance. The two sets of resistors are out of three resistors connected in series between the switches and both terminals of the battery modules, apart from the resistor connected to the central terminal. The capacitors are connected to a positive-electrode terminal of the top battery module out of the two battery modules connected in series and a negative-electrode terminal of the end battery module out of the two battery modules connected in series.

A ninth voltage detecting device for battery modules is based on the sixth voltage detecting device for battery modules, and includes the three-battery-module-type battery unit whose circuit is composed of three sets of battery modules connected in series and three-battery-module filter block which includes four sets of resistors having the equal resistance value, two sets of end capacitors having the equal capacitance, a negative-electrode-side peripheral capacitor having the equal capacitance, and a positive-electrode-side peripheral capacitor having the equal capacitance.

The four sets of the resistors are connected in series between the switches and both terminals of the three sets of battery modules. The two sets of end capacitors. The two sets of the end capacitors are connected between contact points which are disposed between the switches and the resistors connected to both terminals of end battery modules out of the three battery modules connected in series. The negative-electrode-side peripheral capacitor is connected between contact points which are disposed between the switches and the two sets of resistors. The two sets of resistors are respectively connected to a negative-electrode terminal of the top battery module out of the three battery modules connected in series and a negative-electrode terminal of the end battery module out of the three battery modules connected in series. The positive-electrode-side peripheral capacitor is connected between contact points which are disposed between the switches and another two sets of resistors. The two sets of resistors are respectively connected to a positive-electrode terminal of the end battery module out of the three battery modules connected in series and a positive-electrode terminal of the top battery module out of the three battery modules connected in series.

A tenth voltage detecting device for battery modules is based on any one of the third to sixth voltage detecting devices for battery modules, and includes the-four-battery-module-type battery unit whose circuit is composed of four sets of battery modules connected in series and the four-battery-module filter block which includes four sets of resistors having the equal resistance value, two sets of end capacitors having the equal capacitance, a negative-electrode-side peripheral capacitor having the equal capacitance, and a positive-electrode-side peripheral capacitor having the equal capacitance.

The resistors are connected in series between the switches and both terminals of the four sets of battery modules, apart from the resistor connected to the central terminal. The two sets of the end capacitors are connected between contact points which are disposed between the switches and the resistors connected to both terminals of end battery modules out of the battery modules constituting the four-battery-module-type battery unit. The negative-electrode-side peripheral capacitor is connected between contact points which are disposed between the switches and the two sets of resistors. The two sets of resistors are respectively connected to a negative-electrode terminal of the top battery module out of the battery modules connected in series and a negative-electrode terminal of the end battery module out of the battery modules connected in series. The positive-electrode-side peripheral capacitor is connected between contact points which are disposed between the switches and another two sets of resistors. The two sets of resistors are respectively connected to a positive-electrode terminal of the end battery module out of the battery modules connected in series and a positive-electrode terminal of the top battery module out of the battery modules connected in series.

The voltage detecting device for the battery module of the present invention can reduce the difference in frequency response of the battery module whose voltage is detected.

Brief Description of the Drawings

FIG.1 is a block diagram of a voltage detecting device for battery modules of a first embodiment of the present invention.

FIG.2 is a circuit diagram of an anti-aliasing filter where one battery module is provided.

FIG.3 is a circuit diagram of the anti-aliasing filter where two battery modules are provided.

FIG.4 is a circuit diagram of the anti-aliasing filter where three battery modules are provided.

FIG.5 is a circuit diagram of the anti-aliasing filter where four battery modules are provided.

FIG.6 is a table of the number of battery modules corresponding to the ordinal position of a capacitor in order to show a capacitance ratio of the capacitor constituting the anti-aliasing filter.

FIG.7 is a block diagram of a voltage detecting device for battery modules of a second embodiment of the present invention.

FIG.8 is a circuit diagram of the voltage detecting device where one battery module is provided with respect to the voltage detecting device for battery modules of the present invention.

FIG.9 is a circuit diagram of the voltage detecting device where two battery modules are provided with respect to the voltage detecting device for battery modules of the present invention.

FIG. 10 is a circuit diagram of the voltage detecting device where three battery modules are provided with respect to the voltage detecting device for battery modules of the present invention.

FIGs.11A to 11C are a circuit diagram to explain the influence of the output voltage of each battery module in the case where three battery modules are provided with respect to the voltage detecting device for battery modules of the present invention.

FIG.12A to 12D are a circuit diagram to explain the replacement of capacitors in an equivalent circuit where three battery modules are provided.

FIG.13 is a circuit diagram of the voltage detecting device where four battery modules are provided.

FIGs.14A and 14B are a circuit diagram to explain the replacement of capacitors in an equivalent circuit where five battery modules are provided.

FIGs.15A and 15B are a circuit diagram to explain the replacement of capacitors in an equivalent circuit where ten battery modules are provided.

FIGs.16A and 16B are a circuit diagram to explain the replacement of capacitors in an equivalent circuit where twelve battery modules are provided.

FIG. 17 is a circuit diagram of the voltage detecting device where four battery modules are provided with respect to the voltage detecting device for battery modules of the present invention.

FIG. 18 is a circuit diagram of the voltage detecting device where five battery modules are provided with respect to the voltage detecting device for battery modules of the present invention.

FIG. 19 is a circuit diagram of the voltage detecting device where six battery modules are provided with respect to the voltage detecting device for battery modules of the present invention.

FIG.20 is a circuit diagram of the voltage detecting device where seven battery modules are provided with respect to the voltage detecting device for battery modules of the present invention.

FIG.21 is a circuit diagram of the voltage detecting device where eight battery modules are provided with respect to the voltage detecting device for battery modules of the present invention.

FIGs.22A to 22D is a circuit diagram of each battery-module-type battery unit of the voltage detecting device for battery modules of the present invention.

FIG.23 is a circuit diagram of the voltage detecting device for battery modules wherein a flying capacitor topology is applied.

FIGs.24A and 24B are another circuit diagrams of the voltage detecting device for battery modules wherein a flying capacitor topology is applied.

FIG.25 is a circuit diagram of the voltage detecting device for battery modules wherein a plurality (twelve) of battery modules are provided.

FIG.26 is a graph of a frequency characteristic curve of the anti-aliasing filter shown in the circuits of FIGs.2, 14A, and14B.

FIG.27 is a circuit diagram of a switched capacitor circuit.

Detailed Description of the Preferred Embodiments

[First Embodiment]

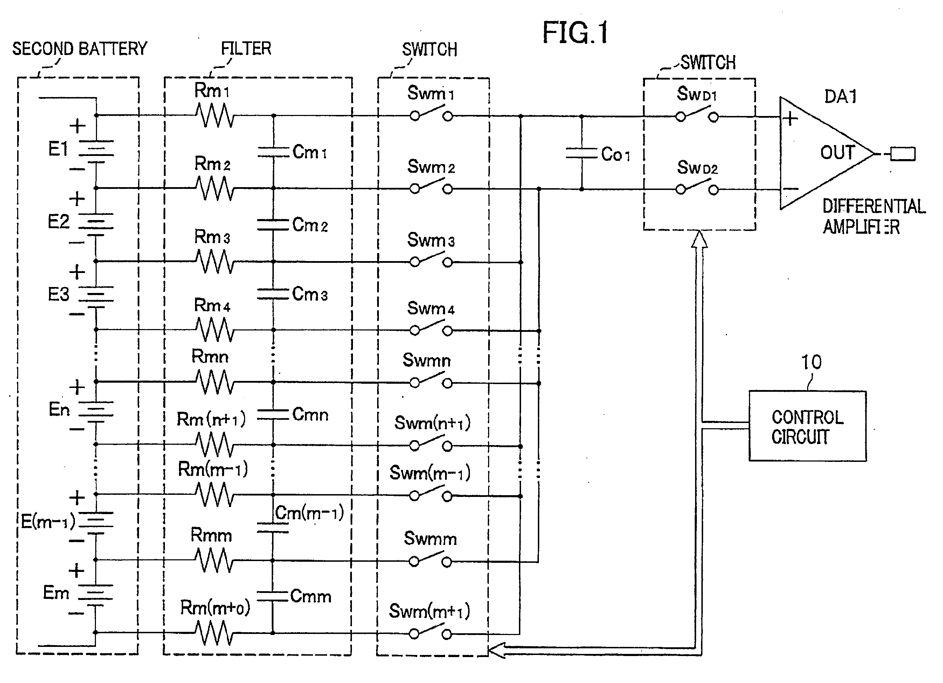

FIG.1 is a block diagram of a voltage detecting device for battery modules of an embodiment of the present invention.

In FIG.1, the voltage detecting device for battery modules of the embodiment measures the voltage of a battery module constituting a secondary battery being the object to be measured. The secondary battery includes a plurality of battery modules E1 to En, and Em connected in series and manufactured under the same standard. The voltage detecting device for battery modules includes an anti-aliasing filter Fa, switches Swm1 to Swm(m+1), a capacitor Co1, switches Swd1 and Swd2, a differential amplifier DA1, and a control circuit 10. A photo MOS (Metal Oxide Semiconductor) relay is applied for the switches Swm1 to Swm(m+1) and the switches Swd1 and Swd2.

Since the voltage of the whole secondary battery is too high to be measured, and each operation of the battery modules E1 to Em needs to be determined, the voltage of each battery module is measured by sequentially controlling the opening and closing of the switches Swm1 to Swm(m+1).

For example, when a battery module E1 is measured, a pair of switches Swm1 and Swm2 is closed, a voltage of the battery module E1 is applied, and the capacitor Co1 is charged. The pair of switches Swm1 and Swm2 is opened after a predetermined time period, the switches Swd1 and Swd2 are closed, and an A/D (analog to digital) converter (not shown) detects a voltage applied to the capacitor Co1 via a differential amplifier DA1. The voltage of the battery modules E1 to Em is sequentially detected.

The capacitor Co1 is charged when a voltage applied to one of the capacitors Cm1 to Cmm is applied to the capacitor Co1 by closing a pair of switches out of switches Swm1 to Swm(m+1) which are connected to output terminals of the battery modules via resistors. The pair of switches is opened after a predetermined time period, the switches Swd1 and Swd2 are closed, and the A/D converter detects a voltage applied to the capacitor Co1 via the differential amplifier DA1. The voltage of the battery module is determined on the basis of the detecting value. A control circuit 10 controls turning on/off the switches Swm1 to Swm(m+1) and the switches Swd1 and Swd2 during operation.

Hereinafter, the operation of the anti-aliasing filter will be described. The anti-aliasing filter mainly eliminates an alternating-current component (noise component) of the voltage of the battery module with respect to the voltage detecting device for battery modules. Even alternating-current voltage component is superposed on the voltage of each battery modules. The anti-aliasing filter is provided to eliminate an alternating-current component in a frequency bandwidth (bandwidth higher than half the sampling frequency), in which the aliasing occurs, from the superposed alternating-current component.

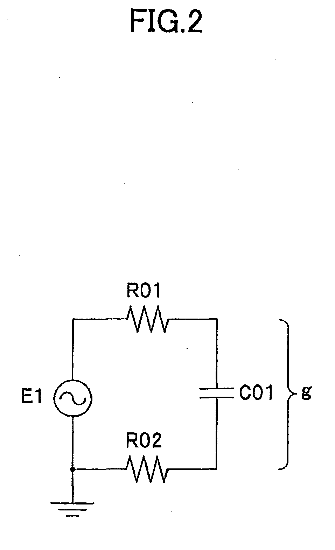

The anti-aliasing filter will be described with reference to FIG.2, where one battery module is provided.

In the case where the impedance (resistance value) of resistors R01 and R02 is "R", capacitance of a capacitor C01 is "C0", and the impedance of the capacitor C01 is "Z". "Z" is described as follows; $Z = (1 / j\omega C0)$. When an alternating-current voltage component V1 of the battery module E1 is an input, and a voltage applied to the capacitor C01 is an output, an input-output gain G1 is described as follows;

$$G1 = VC1 / V1 = Z / (2R+Z) \cdots\cdots(1)$$

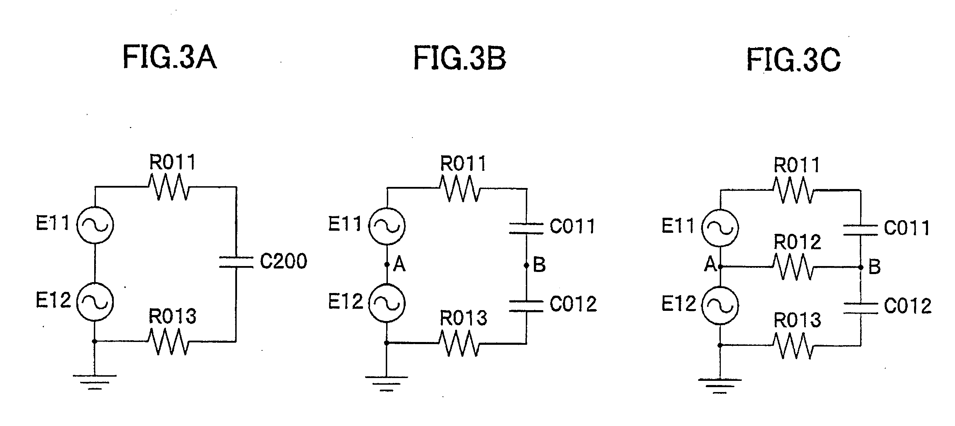

FIG.3 shows the case where two battery modules are provided.

In FIG.3A, a resistance value of resistors R011 and R013 is "R", a capacitance value of a capacitor C200 is "C0", the impedance of the capacitor C200 is "Z", and alternating-current voltage components of battery modules are "V11", and "V12" respectively, namely, (V11= V12 = Vi). In the case where any one of an alternating-current voltage component V11 of a battery modules E11 and an alternating-current voltage component V12 of a battery modules E12 is an input, which is equal to a voltage VI, and a voltage VC200 applied to a capacitor C200 is an output, an input-output gain G200 is described as follows;

$$G200 = VC200 / VI = 2Z / (2R+Z) \cdots\cdots(2)$$

As shown in FIG.3B, the capacitor C200 having the capacitance value C0 (FIG.3A) is replaced with two capacitors C011 and C012 connected in series and having a capacitance value 2C0 twice as much as the capacitance value C0.

According to this replacement, the output voltage VC200 is evenly divided in two. In this case that voltages VC11 and VC12 applied to the capacitors C011 and C012 are an output respectively, an input-output gain G2 is described as follows;

$$G2 = VC11 / VI = VC12 / VI = Z / (2R+Z) \cdots (3)$$

As equations (1) and (3) become equal, each of two filters in FIG.3B has an equivalent frequency response of one filter in FIG.2 where one battery module is provided.

An electric potential of a point A disposed between the battery module E11 and the battery module E12 becomes equal to that of a point B disposed between the capacitor C011 and the capacitor C012. Accordingly, these points can be connected via a resistor R012 having a predetermined resistance value. FIG.3B can be replaced with FIG.3C.

In this case that a capacitance value of the capacitor C200 is "C0", a capacitance value C' of the capacitors C011 and C012 is described as follows;

$$C' = 2 \times C0 = 2C0$$

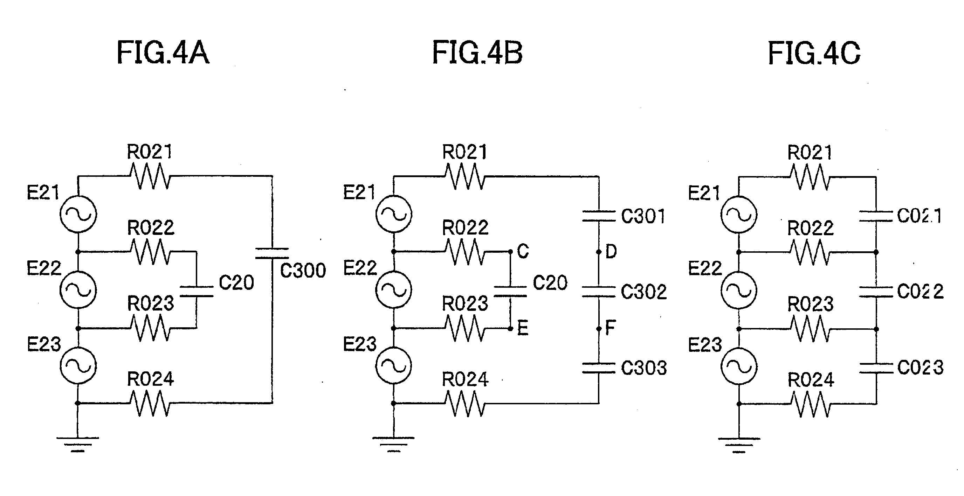

FIG.4 shows the case that three battery modules are provided.

In FIG.4A where a resistance value of resistors R021 to R024 is "R", a capacitance value of capacitors C200 and C300 is "C0", the impedance of the capacitors C200 and C300 is "Z", alternating-current voltage components of battery modules E21, E22, and E23 are "V21", "V22", and "V23" respectively. The alternating-current voltage components V21, V22, and V23 are equal to a voltage Vi (V21 = V22 = V23 = Vi). In the case that the voltage Vi is an input, and the voltage VC20 applied to the capacitor C20 is an output, an input-output gain Gc20 described as follows;

$$Gc20 = VC20 / Vi = Z / (2R + Z)$$

$$G300 = VC300 / Vi = 3Z / (2R + Z)$$

As shown in FIG.4B, the capacitor C300 having the impedance Z is replaced with three capacitors C301, C302, and C303, each of the three capacitors has a third of the impedance Z.

According to this replacement, the total output voltage of the battery modules E21, E22, and E23 is evenly divided into three. In the case that each voltage applied to the capacitors C301, C302, and C303 is an output, the input-output gains G301, G302, and G303 are respectively described as follows;

$$G301 = VC301 / Vi$$

$$= G302 = VC302 / Vi$$

$$= G303 = VC303 / Vi = Z / (2R + Z)$$

In this time, each capacitance value of the capacitors C301, C302, and C303 is equal to a capacitance value C3 which is a third of the capacitance value C0 of the capacitors C300.

$$C3 = 3 \times C0$$

Electric potentials across the capacitor C302 disposed between points D and F are equal to electric potentials across the capacitor C20 isposed between points C and E. Accordingly, the point C can be connected to the point D, and the point E connected to the point F. As shown in FIG.4C, the capacitors C20 and C302 can be replaced with one capacitor C022. According to this replacement, capacitance values C'021, C'022, and C'023 of the capacitors C021, C022, and C023 are described as follows;

$$C'021 = 3C0$$

$$C'022 = 3C0 + C0 = 4C0$$

$$C'023 = 3C0$$

In this time, each gain of the filters is described as Z / (2R + Z), so that each of three filters in FIG.4C has an equivalent frequency response of one filter where one battery module is provided.

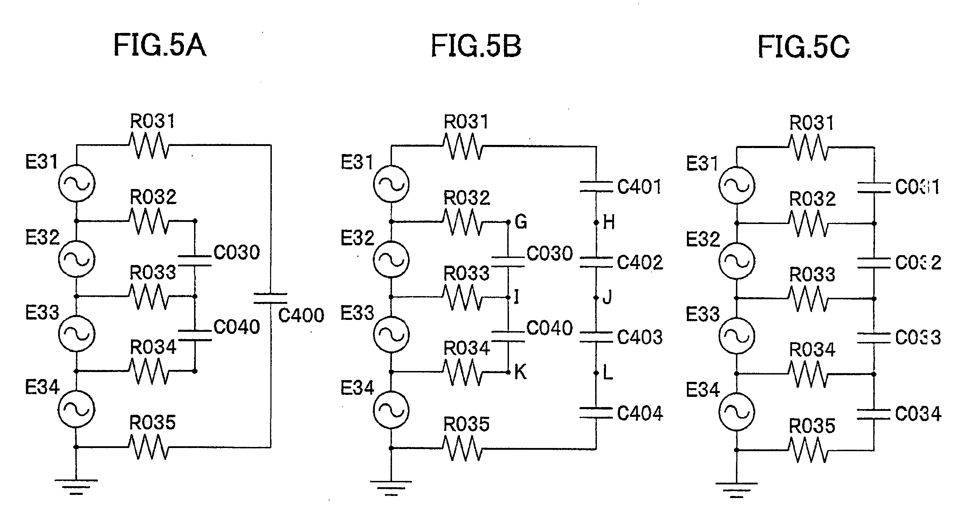

FIG.5 shows the case that four battery modules are provided.

In FIG.5A where a resistance value of resistors R031 to R035 is "R", a capacitance value of capacitors C030 and C040 is "2C0", an impedance of the capacitors C030 and C040 is "Zc30", the impedance Zc30 is described as follows;

$$Zc30 = Zc40 = Z / 2$$

In the case that the capacitance value of a capacitor C400 is "C0", and the impedance of the capacitor C400 is "Z", and alternating-current voltage components V31, V32, V33, and V34 of battery modules E31, E32, E33, and E33 are described as follows;

$$V31 = V32 = V33 = V34 = Vi$$

In the case that the voltage Vi is an input, and the voltages VC30 and VC40 applied to the capacitors C030 and C040 are an output respectively, the input-output gains Gc30 and Gc40 are described as follows;

$$Gc30 = VC30 / Vi = Gc40 = VC40 / Vi = Z / (2R + Z)$$

In the case that 4Vi is an input, and the voltage VC400 applied to the capacitor C400 are an output, the input-output gain G400 is described as follows;

$$G400 = VC400 / Vi = 4Z / (2R + Z)$$

As shown in FIG.5B, the capacitor C400 having a capacitance value C0 is replaced with four capacitors C401, C402, C403, and C404 connected in series, and each capacitance value C4 of the four capacitors is four times as much as the capacitance value C0 (a fourth of the impedance Z).

According to this replacement, a total output voltage of battery modules E31, E32, E33 and E34 is evenly divided into four. In the case that respective voltages VC401 to VC404 applied to the capacitors C401 to C404 are an output, and the input voltage Vi is an input, input-output gains G401 to G404 are respectively described as follows;

$$G401 = VC401 \:/\: Vi$$

$$= G402 = VC402 \:/\: Vi$$

$$= G403 = VC403 \:/\: Vi$$

$$= G404 = VC404 \:/\: Vi = Z \:/\: (2R + Z)$$

In this case that the capacitance value of the capacitor C400 is "C0", each of capacitance values C401a, C402a, C403a, and C404a of the capacitors C401, C402, C403 and C404 is four times as much as the capacitance value C0.

$$C401a = C402a = C403a = C404a = 4C0$$

As described above with reference to FIG.4, according to FIG.5B electric potentials at point G and H are equal, so that the two points G and H can be connected. Furthermore, electric potentials at point I and J are equal, so that the two points I and J can be connected. Electric potentials at point K and L are equal, so that the two points K and L can be connected. Consequently, FIG.5B can be replaced with FIG.5C.

Capacitance values C'031 to C'034 of the capacitors C31 to C34 are respectively described as follows;

$$C'031 = 4C0$$

$$C'032 = 4C0 + 2C0 = 6C0$$

$$C'033 = 4C0 + 2C0 = 6C0$$

$$C'034 = 4C0$$

In this time, the input-output gain of each filter in FIG.5C is described as Z / (2R + Z), so that each of the filters has an equivalent frequency response of one filter where one battery module is provided.

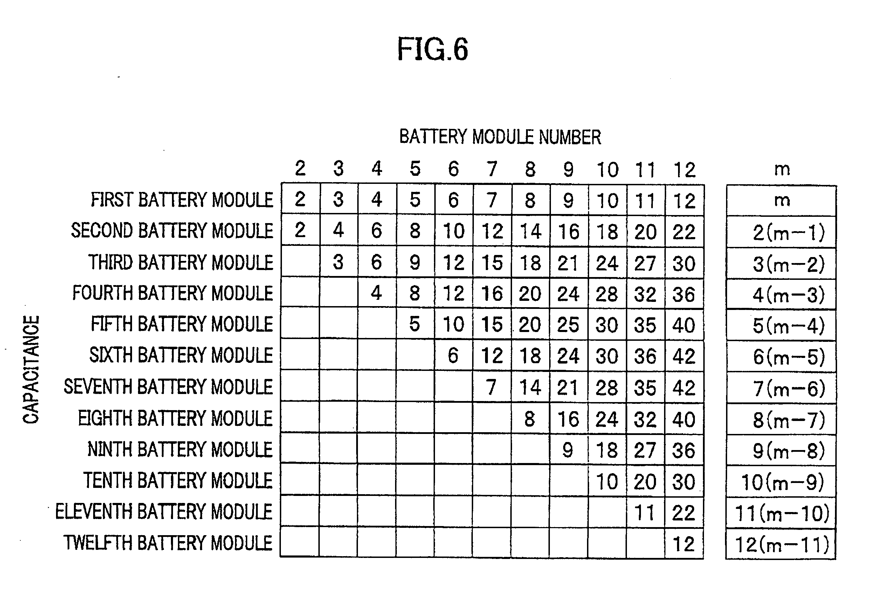

If the number of battery modules is five or more, the impedance of the capacitor can be determined in the same way described above. The capacitance ratio per capacitor is shown in a table of FIG.6. The table of FIG.6 shows a relation of the capacitance of the capacitor based on its ordinal position N to the number M of battery modules. When one battery module is provided, the capacitance of one capacitor is regarded as "one" on the table.

Generally, an arbitrary capacitance value of the capacitor forming the anti-aliasing filter for a secondary battery having M sets of battery modules can be described below. The arbitrary capacitance value of each capacitor depends on its ordinal position. A first capacitor is disposed in parallel with the end or top battery module out of a plurality of battery modules composed of the secondary battery.

| | |
|---|---|
| First Capacitor | MC0 |
| Second Capacitor | 2(M-1)C0 |
| Third Capacitor | 3(M-2)C0 |
| Fourth Capacitor | 4(M-3)C0 |
| Fifth Capacitor | 5(M-4)C0 |
| ------- | |
| N number of Capacitor | n(M-N+1)C0 |

(continued)

--------

| | |
|---|---|
| (M-1) number of Capacitor | 2(M-1)C0 |
| M number of Capacitor | MC0 |

Accordingly, the capacitance of the capacitors for the anti-aliasing filter can be adjusted, so that the anti-aliasing filter can reduce the difference in frequency response with respect to the secondary battery having an arbitrary number of battery modules.

As mentioned above, the capacitance of the capacitor is described in the ratio based on the reference capacitance value C0. The resistance value R of the resistor constituting the anti-aliasing filter is constant, but not limited. Accordingly, the capacitance value C0 and the resistance value R can be selectable, so that the anti-aliasing can provide a wide range of cut-off frequency.

As described above, the embodiment of the present invention can reduce the difference in frequency response of the battery module whose voltage is detected. When there is no difference in output voltage waveform of each battery module, there is no difference in a voltage waveform through the filter. Consequently, the embodiment of the present invention can prevent the battery modules from erroneously being determined as if it were in an irregular condition. When a photo MOS relay is provided, a sampling frequency of switching is forced to be low due to a long delay in switching. However, as the embodiment of the present invention can reduce the difference in frequency responses, the anti-aliasing filter can provide relatively a high cut-off frequency. The voltage detecting device for battery modules includes a flying capacitor wherein a pair of the switches Swm1 and Swm(m+1) and a pair of the switches Swd1 and Swd2 are alternately opened and closed, so that the secondary battery and the differential amplifier are insulated with each other.

[Second Embodiment]

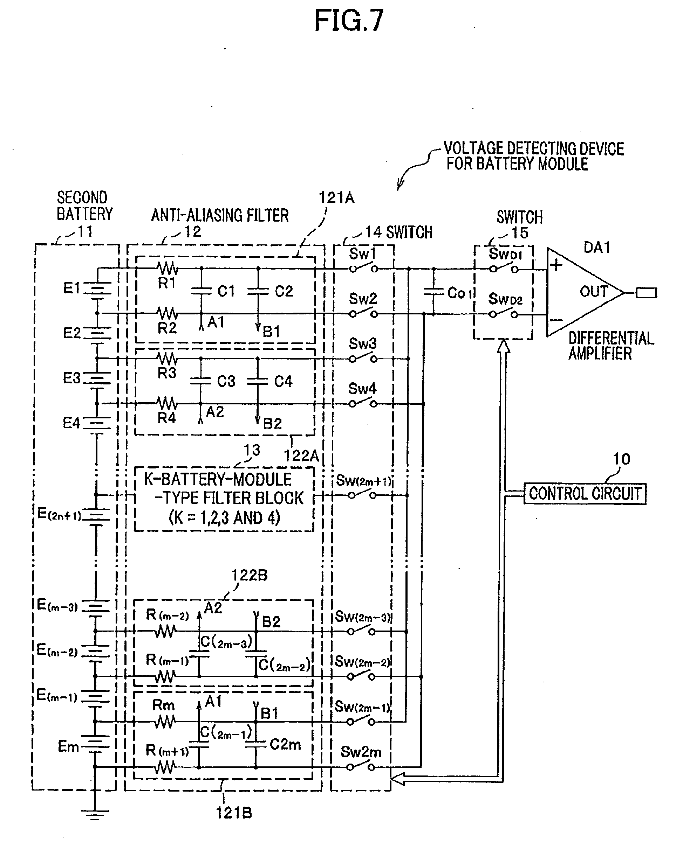

FIG.7 is a block diagram showing a voltage detecting device for battery modules of a second embodiment of the present invention.

In FIG.7, the voltage detecting device for battery modules of the second embodiment measures the voltage of a battery module constituting a secondary battery 11 being the object to be measured. The second battery 11 includes a plurality of battery modules E1 to Em connected in series and manufactured under the same standard. The voltage detecting device for battery modules includes an anti-aliasing filter 12, a switch group 14 comprised of switches Sw1 to Sw2m, a capacitor Co1, output switches 15 comprised of switches Swd1 and Swd2, a differential amplifier DA1, and a control circuit 10. A photo MOS relay is applied for the switches Sw1 to Sw2m and the switches Swd1 and Swd2.

As the voltage of the whole secondary battery is too high to be measured and each operation of the battery modules E1 to Em needs to be determined, each voltage of battery modules E1 to Em is measured by sequentially controlling the opening and closing of the switches Sw1 to Sw2m.

For example, when a battery module E1 is measured, a pair of switches Sw1 and Sw2 is closed, a voltage of the battery module E1 is applied, and the capacitor Co1 is charged. The pair of switches Sw1 and Sw2 is opened after a predetermined time period, the switches Swd1 and Swd2 are closed, and an A/D (analog to digital) converter (not shown) detects a voltage applied to the capacitor Co1 via a differential amplifier DA1. The voltage of the battery module E1 is determined based on the detected value.

The voltage detection process for the battery modules E1 to Em sequentially proceeds in order to determine the voltage of each battery module.

The control circuit 10 controls turning on/off the switches Sw1 to Sw2m and the switches Swd1 and Swd2 during operation.

Hereinafter, the operation of the anti-aliasing filter will be described. The anti-aliasing filter mainly eliminates an alternating-current component (noise component) of the voltage of the battery module with respect to the voltage detecting device for battery modules. When the secondary battery is charged and discharged as a whole, the alternating-current component is superposed on the voltage of each battery module. The anti-aliasing filter is provided to eliminate the alternating-current component in a frequency bandwidth (bandwidth higher than half the sampling frequency), in which the aliasing occurs, from the superposed alternating-current component.

The anti-aliasing filter 12 is composed of a combination of four-battery-module filter block corresponding to four sets of battery modules and any one of four types of battery module filter blocks, depending on the number of battery modules. When the number M of battery modules is (4n +1), the filter block is one-battery-module filter block corresponding to one battery module positioned in the center of the second battery. When the number M of battery modules is (4n +2), the filter block is two-battery-module filter block corresponding to two battery modules positioned in the center of the secondary battery. When the number M of battery module is (4n +3), the filter block is three-battery-module filter block corresponding to three battery modules positioned in the center of the secondary battery. When the number M of battery modules is 4n, the filter block is four-battery-module filter block corresponding to four battery modules positioned in the center of the secondary battery.

The four-battery-module filter block is symmetrical about a fold-back point which is the center of the secondary battery and divided into two groups, which are a positive terminal side and a negative terminal side. On the positive terminal side, N sets of the four-battery-module filter blocks are disposed in order from the positive terminal. On the negative terminal side, N sets of the four-battery-module filter blocks are disposed in order from the negative terminal. In FIG.7, reference numeral 121A denotes the four-battery-module filter block positioned in the nearest to the positive terminal of the secondary battery on the positive terminal side, and reference numeral 122A denotes the four-battery-module filter block positioned in the second nearest to the positive terminal. Reference numeral 121B denotes the four-battery-module filter block positioned in the nearest to the negative terminal with respect to the group on the negative terminal side, and reference numeral 122B denotes the four-battery-module filter block positioned in the second nearest to the negative terminal.

Reference numeral 13 denotes any one of the one-battery-module filter block, the two-battery-module filter block, the three-battery-module filter block, and the four-battery-module filter block.

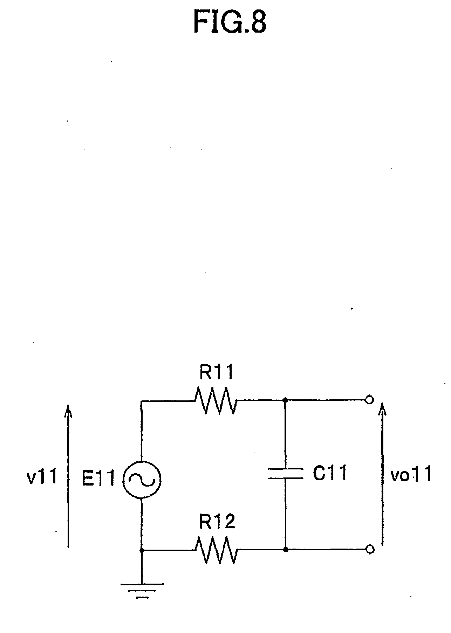

The anti-aliasing filter will be described with reference to FIG.8, where one battery module is provided.

In the case that the impedance (resistance value) of resistors R11 and R22 is "R", capacitance of a capacitor C11 is "C0", and the impedance of the capacitor C11 is "Z", the impedance Z is described as follows; $Z =(1 / j\omega C0)$. In the case that an alternating-current voltage component V11 of the battery module E11 is an input, and a voltage Vo11 applied to the capacitor C11 is an output, an input-output gain G1 is described as follows;

$$G1 = Vo11 / V11 = Z / (2R+Z) \quad \cdots(4)$$

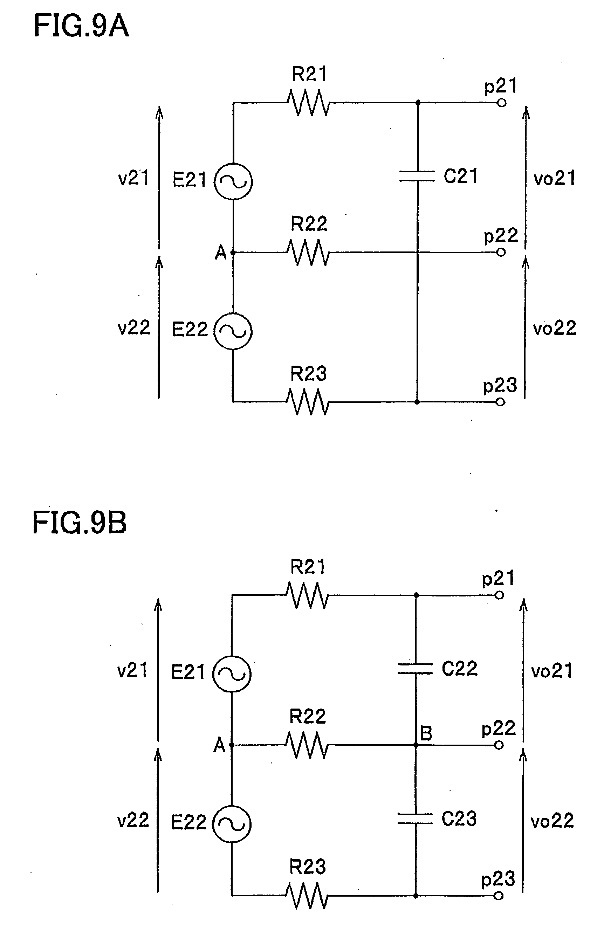

FIG.9 shows the case where two battery modules are provided.

In FIG.9A, a resistance value of resistors R21 and R23 is "R", a capacitance of a capacitor C21 is "C0", an impedance of the capacitor C21 is "Z", and alternating-current voltage components of battery modules E21 and E22 are "V21", and "V22" respectively (V21 = V22 = Vi).

In the case that the voltage Vi superposed with any one of an alternating-current voltage component V21 of a battery module E21 and an alternating-current voltage component V22 of a battery module E22 is an input, and the voltage VC21 applied to a capacitor C21 is an output, the input-output gain G21 is described as follows;

$$G21 = VC21 / Vi = 2Z / (2R+Z) \cdots(5)$$

The alternating-current voltage component V21 of the battery module E21 and the alternating-current voltage component V22 of the battery module E22 are equal. A point A is disposed between the battery module E21 and the battery module E22. Accordingly, an alternating-current voltage component Vo21 between a point 21 on the output side of a resistor R21 and a point 22 on the output side of a resistor R22 is equal to an alternating-current voltage component Vo22 between a point 23 on the output side of a resistor R23 and the point 22 on the output side of the resistor R22. The resistor R22 can be of an arbitrary resistance value.

Accordingly, the voltage VC21 applied to the capacitor C21 is evenly divided in two. When alternating-current voltage components Vo21 and Vo22 is an output respectively, an input-output gain G2 is described as follows;

$$G2 = Vo21 / Vi = Vo22 / Vi = Z / (2R +Z) \quad \cdots(6)$$

As equations (1) and (3) become equal, each of two filters, on which the alternating-current components are applied respectively, has an equivalent frequency response of the filter where one battery module is provided.

As shown in FIG.9B, the capacitor C21 having a capacitance value C0 is replaced with two capacitors C22 and C23 connected in series. Each of the capacitors C22 and C23 has twice as much as the capacitance C0.

According to this replacement, the output voltage VC21 is evenly divided in two. In this case that the voltage Vo21 applied to the capacitor C22 and the voltage Vo22 applied to the capacitor C23 are an output respectively, the input-output gain G2 is described as follows;

$$G2 = Vo21 / Vi = Vo2 / Vi = Z / (2R+Z) \cdots (7)$$

Consequently, the equation (7) corresponds to the previous result.

Next, the case where three battery modules are provided will be described.

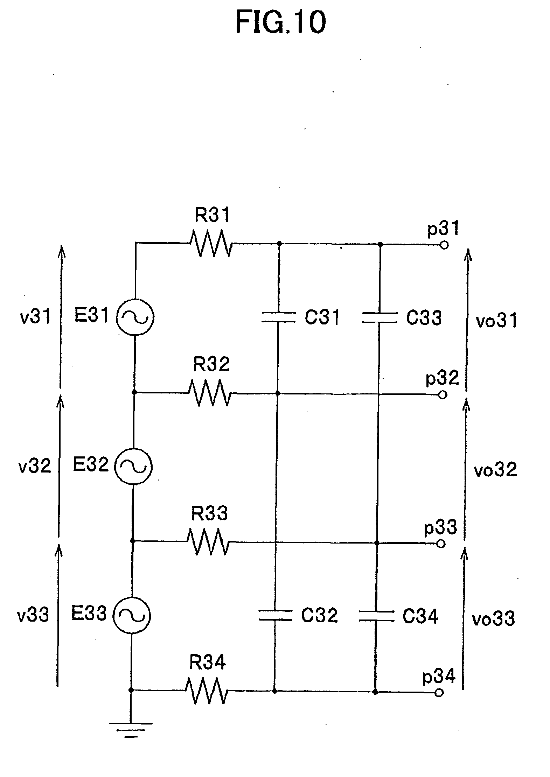

In FIG. 10, a resistance value of resistors R34 and R34 is "R", capacitance value of capacitors C31 to C34 is "C0", impedance of the capacitors C31 to C34 is "Z". The battery modules E31 and E33 are called as an end battery module, the capacitors C31 and C34 are called as an end capacitor, the capacitor C32 is called as a negative-side peripheral capacitor, and the capacitor C33 is called as a positive-side peripheral capacitor.

Alternating-current voltage components V31, V32, and V33 of battery modules E31, E32, and E33 are equal to the voltage Vi (V31 = V32 = V33 =Vi).

In this time, alternating-current voltage component Vo31 between an output terminal P32 of a resistor R32 and an output terminal P31 of a resistor R31 is measured, and an alternating-current voltage component Vo32 between an output terminal P33 of a resistor R33 and the output terminal P32 of the resistor R32 as well as an alternating-current voltage component Vo33 between an output terminal P34 of a resistor R34 and the output terminal P33 of the resistor R33 are measured respectively.

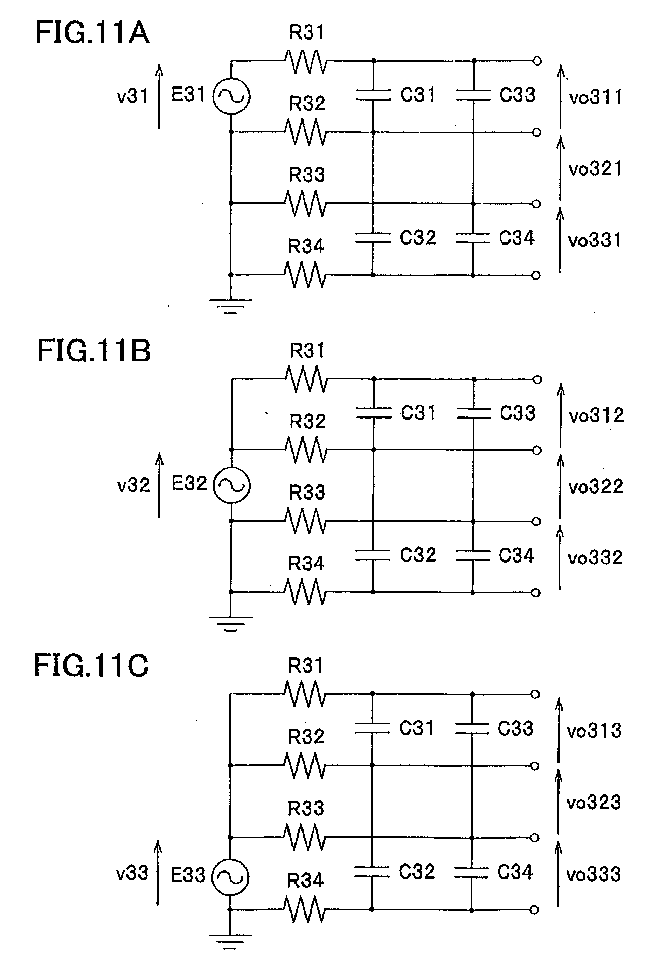

For convenience sake, as shown in FIG.11A, when the alternating-current voltage components V32 and V33 are equal to zero (V32 = V33 = 0), an alternating-current voltage component Vo311 corresponding to the alternating-current voltage component V31 is described as follows;

$$Vo311 = Vi\ Z\ (3R +Z) / \{\ (2R + Z)\ (4R + Z)\} \cdots (8)$$

As shown in FIG.11B, the alternating-current voltage components V31 and V33 are equal to zero (V31 = V33 = 0). As an R31-C33-R33 path is equivalent to an R32-C32-R34 path, there is no electric potential difference across the capacitors C31 and C34 which are respectively disposed between the R32 and R33, and between the R33 and R34. Accordingly, the alternating current voltage component Vo312 corresponding to the alternating-current voltage component V32 becomes equal to zero (Vo312 = 0).

As shown in FIG.11C, when the alternating-current voltage components V31 and V33 are equal to zero (V31 = V33 = 0), the alternating-current voltage component Vo313 corresponding to the alternating-current voltage component V33 is described as follows;

$$Vo313 = Vi\ R\ Z / \{\ (2R + Z)\ (4R + Z)\} \cdots (9)$$

When the alternating-current voltage components V31, V32 and V33 are equal to the voltage Vi, the alternating-current voltage component Vo31 is described as follows;

$$Vo31 = Vo311 + Vo312 + Vo313 = Vi\ Z / (2R +Z)$$

As the alternating-current voltage component Vo33 is equivalent to the alternating-current voltage component Vo31, the alternating-current voltage component Vo33 is described as follows;

$$Vo33 = Vi\ Z / (2R + Z)$$

A voltage VC32 applied to the capacitor C32 needs to be measured in order to determine the value of the alternating-current voltage component Vo32.

As described in the case where the alternating-current voltage component Vo is determined, assuming that each of the voltages V31, V32, and V33 is individually applied, a voltage is generated between the point 31 and the point 32, between the point 32 and the point 33, between the point 33 and the point 34 respectively. Furthermore, when the voltage generated between the point 32 and the point 34 is added, the voltage VC32 is described as follows;

$$VC32 = Vi\ R\ Z\ /\ \{(2R + Z)\ (4R + Z)\}$$

$$+ Vi\ Z\ /\ (2R + Z)$$

$$+ Vi\ Z\ (3R + Z\ )\ /\ \{(2R + Z)\ (4R + Z)\}$$

$$= Vo31 + Vi\ Z\ /\ (2R + Z) \cdots (10)$$

Consequently, the alternating-current voltage component Vo32 is described as follows;

$$Vo32 = VC32 - Vo33 = VC32 - Vo31 = Vi\ Z\ /\ (2R + Z)$$

Accordingly, since the alternating-current voltage components Vo31, Vo32 and Vo33 are equal to equation (4), each of the filters in FIG.11C has an equivalent frequency response of one filter where one battery module is provided.

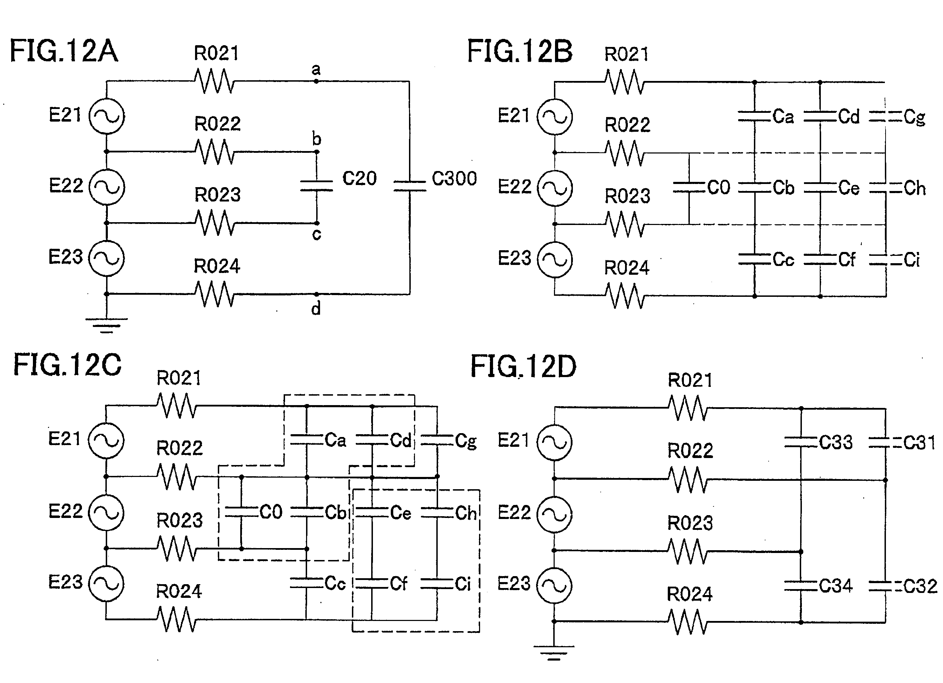

According to FIGs.12A to 12D, the circuit of FIG.4A is equivalent to the circuit of FIG.10. FIG.12A shows the same circuit of FIG.4A. An alternating-current power supply E22 is connected in series to resistors R022 and R023 and a capacitor C20. An alternating-current power supply E21 is connected in series to resistors R021 and R024 and a capacitor C300. The capacitor 300 is equivalent to a circuit wherein three pairs of capacitors connected in series are connected in parallel, and each of the capacitors has the equal capacitance C0. The capacitor C300 can be replaced with 9 sets of capacitors Ca, Cb, Cc, Cd, Ce, Cf, Cg, Ch, and Cg (FIG.12B).

As explained that the frequency characteristics of the capacitors C21, C22, and C23 are equal with reference to FIGs.4A and 4C, the frequency characteristics between points A and B, between points B and C, and between points C and D in FIG.12B are respectively equal. Accordingly, as shown in FIG.12C, connecting points, between the resistor R022 and the capacitor C0, between the capacitors Ca and Cb, between the capacitors Cd and Ce, between the capacitors Cg and Ch, can be connected. Furthermore, connecting points, between the resistor R023 and the capacitor C0, and between the capacitors Cb and Cc, can be connected.

The capacitors C0, Ca, Cb, and Cd are equivalent to a circuit wherein a pair of capacitors connected in series are connected in parallel, and each of the capacitors has the equal capacitance value C0. Accordingly, the capacitors C0, Ca, Cb, and Cd are equivalent to a capacitor C33 having the capacitance C0. The capacitors Ce, Cf, Ch, and Ci are equivalent to a capacitor C32 having the capacitance value C0 (FIG.12D). Consequently, the circuit of FIG.4A is equivalent to the circuit of FIG.10.

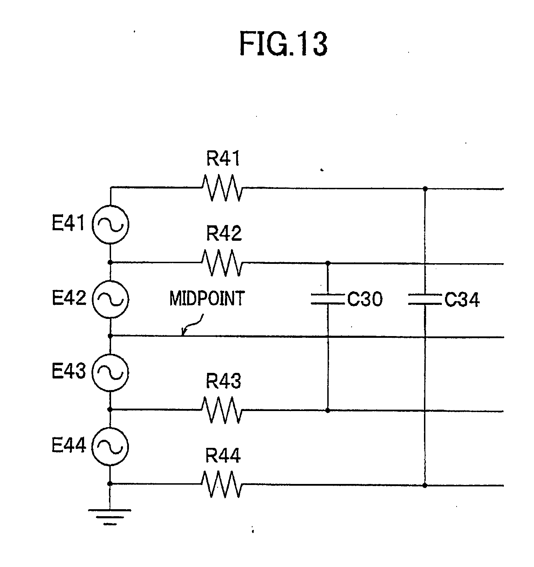

Extensive explanation of the embodiment will be described with reference to FIGs.13 to 16.

In FIG, 13, four sets of battery modules E41, E42, E43, and E44 are connected in series. A series circuit where the resistors R53 and R54 and a capacitor 35 are connected in series is connected to one end of the battery modules E41 and E44. A series circuit where the resistors R42 and R43 and a capacitor 30 are connected in series is connected to one end of the battery modules E42 and E43, which are connected in series. If the number of battery modules is an even number, a capacitor is not connected at a midpoint between the battery modules E42 and E43. Accordingly, the presence of a resistor at the midpoint does not affect the frequency characteristics.

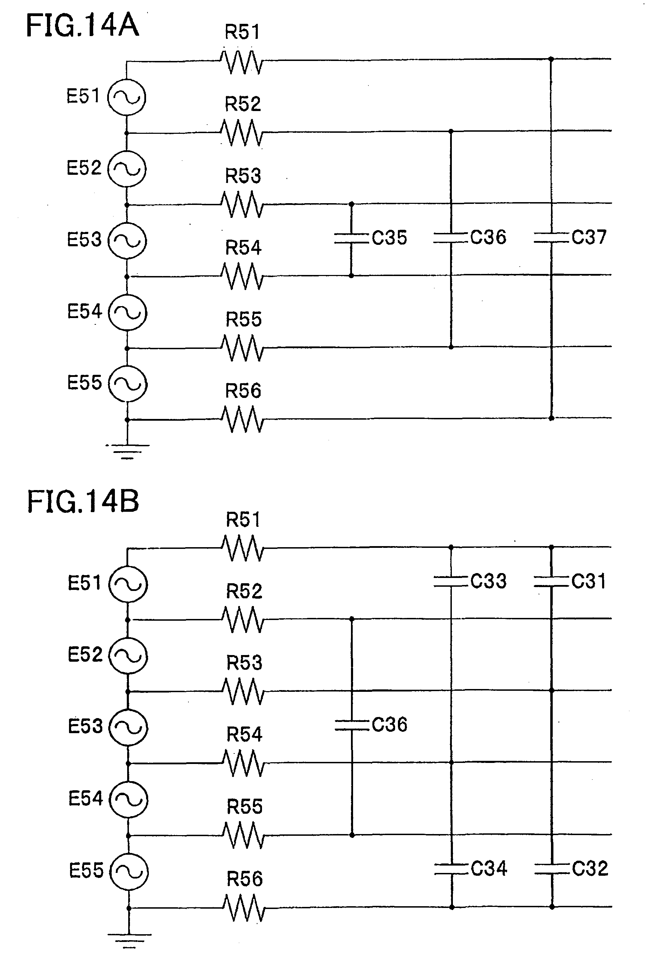

In FIGs. 14A and 14B, five sets of battery modules E51, E52, E53, E54, and E55 are connected in series. In FIG.14A, the battery module E53 is connected to a series circuit in which resistors R53 and R54 and a capacitor C35 are connected in series. The battery modules E52, E53 and E54 connected in series are connected to a series circuit in which resistor R52 and R55 and a capacitor C36 are connected in series. The battery modules E51, E52, E53, E54 and E55 connected in series are connected to a series circuit in which the resistors R51 and R56 and a capacitor C37 are connected in series.

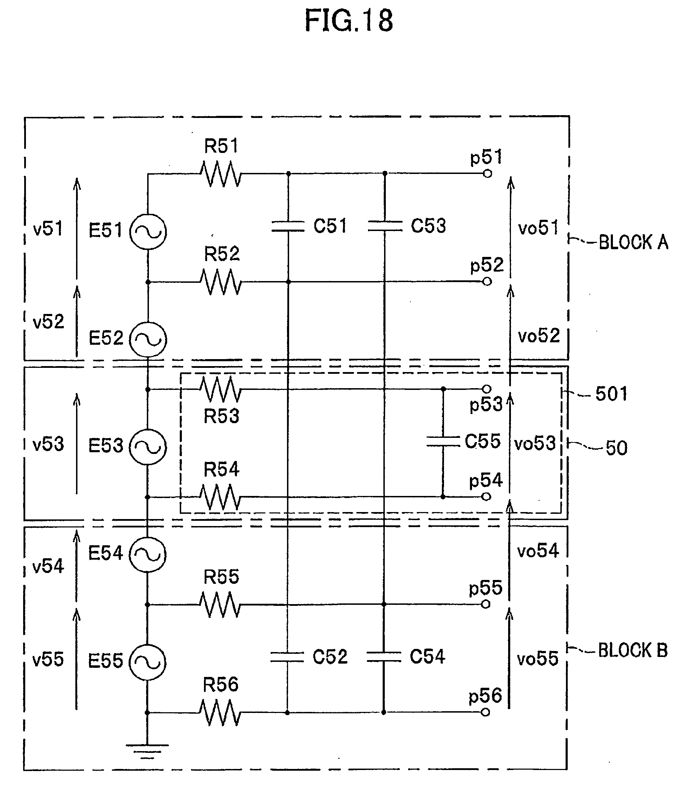

FIG.14B is equivalent to FIG.14A. As explained as for FIG. 12, the capacitors C35 and C37 can be replaced with the capacitors C31, C32, C33, and C34. Accordingly, a voltage applied to the capacitors C32 and C33 is reduced to three-fifths of the voltage applied to the capacitor C37. According to this replacement of the capacitors C36 and C37, FIG.14B becomes equal in structure to FIG.18.

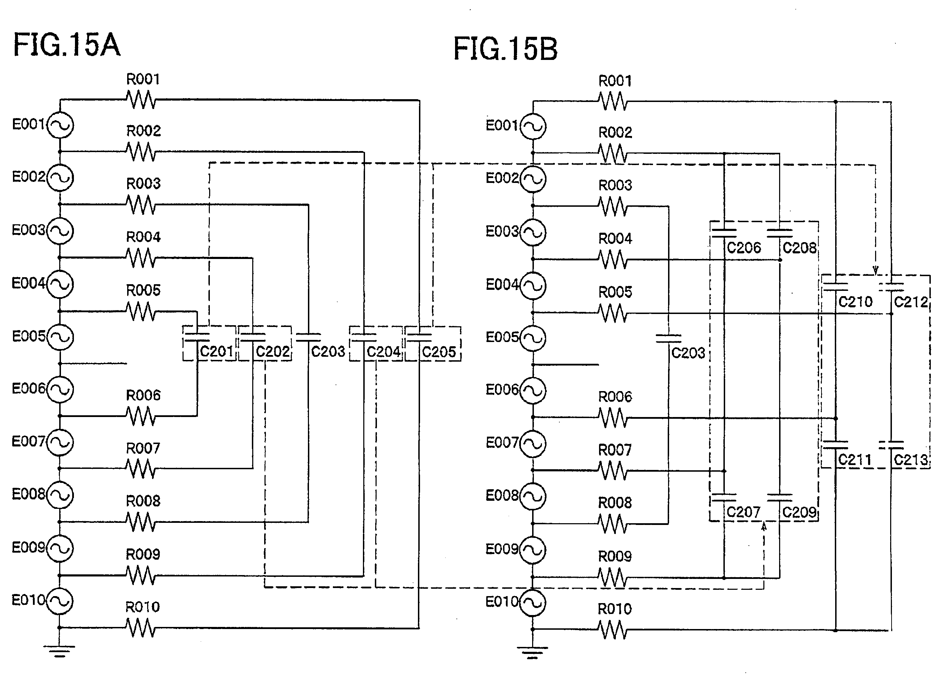

In FIG.15, ten sets of battery modules E001 to E010 are connected in series. In FIG.15A, the battery modules E005 and E006 connected in series are connected to a series circuit in which resistors R005 and R006 and a capacitor C201 are connected in series. The battery modules E004 to E007 connected in series are connected to a series circuit in which resistors R004 and R007 and a capacitor 202 are connected in series. The battery modules E003 to E008 connected in series are connected to a series circuit in which resistors R003 and R008 and a capacitor 203 are connected in series. The battery modules E002 to E009 connected in series are connected to a series circuit in which resistors R002 and R009 and a capacitor C204 are connected in series. The modules E001 to E010 are connected to a series circuit in which resistors R001 and R010 and a capacitor C205 are connected in series.

In FIG.15B, as explained as for the replacement of the capacitors in FIG. 12, the capacitors C202 and C204 can be replaced with the capacitors C206 to C209, and the capacitors C201 and C205 can be replaced with the capacitors C210 to C213.

In other words, the battery modules E002 to E009 are connected to a series circuit in which the capacitors C206 and C207 are connected in series, and a series circuit in which the capacitors C208 and C209 are connected in series. A connecting point between the capacitors C206 and C207 is connected to a point between the battery modules E007 and E008 via a resistor R007. A connecting point between the capacitors C208 and C209 is connected to a connecting point between the battery modules E003 and E004 via a resistor R004.

Further, the battery modules E001 to E010 are connected to a series circuit in which the capacitors C210 and C211 are connected in series, and a series circuit in which the capacitors C212 and C211 are connected in series. A connecting point between the capacitor C210 and C213 is connected to a connecting point between the battery modules E006 and E007 via a resistor R006. A connecting point between the capacitors C212 and C213 is connected to a connecting point between the battery modules E004 and E005 via a resistor R005. As is the case with FIG.15A, the battery modules E003 to E008 are connected to a series circuit in which resistors R003 and R008 and a capacitor C203 are connected in series. In the circuit of FIG.15B, a voltage applied to the capacitors C210 and C213 is reduced to six-tenths of the voltage applied to the capacitor C205 of FIG. 15A, and a voltage applied to the capacitors C206 and C209 is reduced to six-eighths of the voltage applied to the capacitor C204 of FIG.15A.

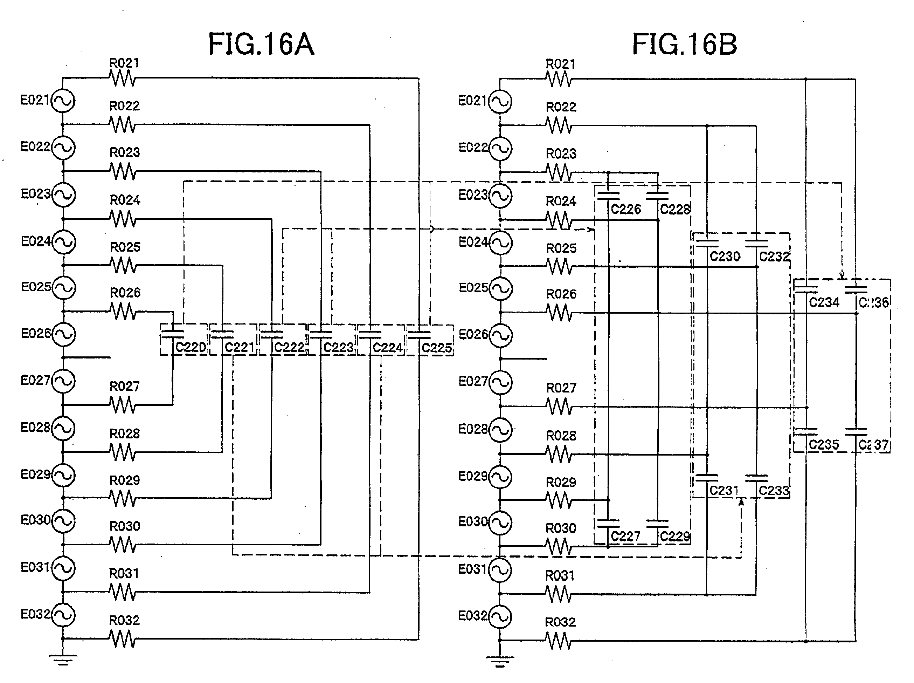

In FIG. 16, twelve sets of battery modules E021 to E032 are connected in series. In FIG.16A, the battery modules E026 and E027 are connected to a series circuit in which resistor R026 and R027 and a capacitor C220 are connected in series. The battery modules E025 to E028 are connected to a series circuit in which resistors R025 and R028 and a capacitor C221 are connected in series. The battery modules E024 to E029 are connected to a series circuit in which resistors R024 and R029 and a capacitor C222 are connected in series. The battery modules E023 and E030 are connected to a series circuit in which resistors R023 and R030 and a capacitor C223 are connected in series. The battery modules E022 to E031 are connected to a series circuit in which resistors R022 and R031 and a capacitor C224 are connected in series. The battery modules E021 and E032 are connected to a series circuit in which resistors R021 and R032 and a capacitor C225 are connected in series. As is the case with FIG.12, the capacitors C220 and C225 can be replaced with the capacitors C234, C235, C236, and C237, the capacitors C221 and C224 can be replaced with the capacitors C230, C231, C232, and C233, and the capacitors C222 and C223 can be replaced with the capacitors C226, C227, C228, and C229.

Consequently, in FIG.16B, the battery modules E023 to E030 are connected via resistors R023 and R030 to a series circuit in which the capacitors C226 and C227 are connected in series, and a series circuit in which the capacitors C228 and C229 are connected in series. A connecting point between the capacitors C230 and C227 is connected via a resistor R029 to a connecting point between the battery modules E228 and E030. A connecting point between the capacitors C228 and C229 is connected via a resistor R024 to a connecting point between the battery modules E023 and E024.

The battery modules E022 and E031 are connected via resistors R022 and R031 to a series circuit in which the capacitors C230 and C231 are connected in series, and a series circuit in which the capacitors C232 and C233 are connected in series. A connecting point between the capacitors C230 and C231 is connected via a resistor R028 to a connecting point between the battery modules E028 and E029. A connecting point between the capacitors C232 and C233 is connected via a resistor R025 to a connecting point between the battery modules E024 and E025.

The battery modules E021 and E032 are connected via resistors R021 and R032 to a series circuit in which the capacitors C236 and C237 are connected in series, and a series circuit in which the capacitors C236 and C237 are connected in series. A connecting point between the capacitors C234 and C235 is connected via a resistor R027 to a connecting point between the battery modules E027 and E028. A connecting point between the capacitors C236 and C237 is connected via a resistor R026 to a connecting point between the battery modules E025 and E026.

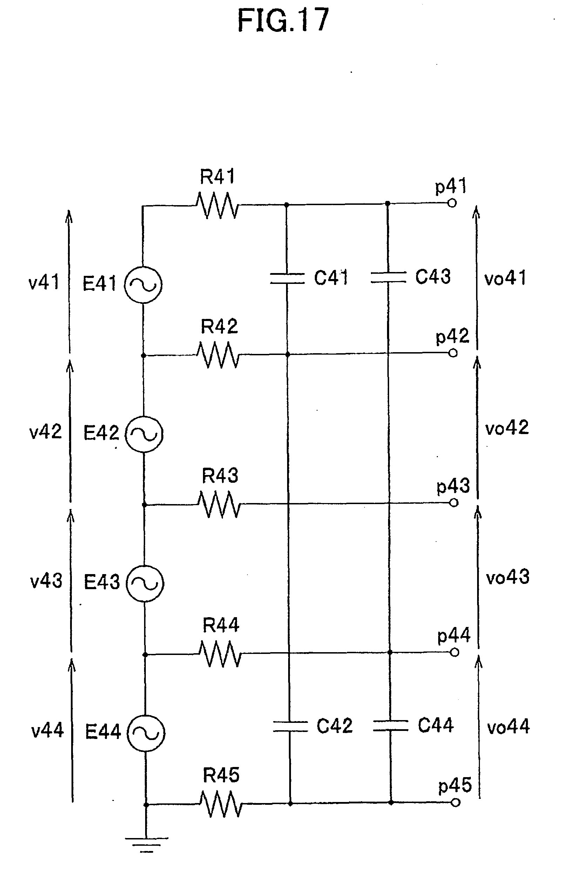

FIG.17 shows the case where four battery modules are provided, apart from the circuit of FIG.13.

In FIG.17, a resistance value of resistors R41 to R44 is "R", capacitance of capacitors C41 to C44 is "C0", impedance of the capacitors C41 to C44 is "Z". Battery modules E41 and E44 are called as an end battery module, the capacitors C41 and C44 are called as an end capacitor, the capacitor C42 is called as a negative-side peripheral capacitor, and the capacitor C43 is called as a positive-side peripheral capacitor.

Alternating-current voltage components V41 to V44 of battery modules E41 to E44 are equal to the voltage Vi (V41 = V42 = V43 = V44 = Vi). As is the case with alternating-current voltage component Vo33, where the three battery modules are provided, alternating-current voltage components Vo41, Vo42, Vo43, and Vo44 are described as follows;

$$Vo41 = Vi\ Z\ /\ (2R + Z)$$

The alternating-current voltage component Vo44 is equivalent to the alternating-current voltage component Vo41. Accordingly, the alternating-current voltage component Vo44 is described as follows;

$$Vo44 = Vi\ Z\ /\ (2R + Z)$$

When the voltages Vi of the battery modules E42 and E43 are added, the sum is twice as much as the voltage Vi. Accordingly, the sum is equal to the total voltage (Vo42 + Vo43) of the alternating-current voltage components Vo42 and Vo43. Accordingly, the total voltage (Vo42+Vo43) is described as follows;

$$Vo42 + Vo43 = 2\ Vi\ Z\ /\ (2R + Z)$$

As the alternating-current voltage component Vo42 is equal to the alternating-current voltage component Vo43, the alternating-current voltage components Vo42 and Vo43 are described as follows;

$$Vo42 = Vo43 = Vi\ Z\ /\ (2R + Z)$$

Accordingly, each of four filters, corresponding the alternating-current voltage components Vo41 to Vo44, has an equivalent frequency response of the filter where one battery module is provided. Since the resistance value of a resistor R43 does not affect the frequency response, the resistor R43 can be of an arbitrary resistance value.

FIG. 18 shows the case where five battery modules are provided, apart from the circuit of FIG.14.

In FIG.18, a resistance value of resistors R51 to R56 is "R", capacitance of capacitors C51 to C55 is "C0", impedance of the capacitors C51 to C55 is "Z". Alternating-current voltage components V51 to V55 of battery modules E51 to E55 are equal to the voltage Vi (V51= V52 = V53 = V44 = V55 = Vi).

As is the case where the three battery modules are provided, alternating-current voltage components Vo51, Vo52, Vo53, Vo54 and Vo55 are described as follows;

$$Vo51 = Vi\ Z\ /\ (2R + Z)$$

The alternating-current voltage component Vo55 is equivalent to the alternating-current voltage component Vo51. Accordingly, the alternating-current voltage component Vo55 is described as follows;

$$Vo55 = Vi\ Z\ /\ (2R + Z)$$

When the voltages Vi of the battery modules E52, E53, and E54 are added, the sum is three times as much as the voltage Vi. Accordingly, the sum is equal to the total voltage (Vo52 + Vo53 + Vo54) of the alternating-current voltage components Vo52, Vo53, and Vo54.

Accordingly, the total voltage (Vo52+Vo53+Vo54) is described as follows;

$$Vo52 + Vo53 + Vo54 = 3\ Vi\ Z\ /\ (2R + Z)$$

A one-battery-module-type battery unit 50 which generates the alternating-current voltage component Vo53 is identical with a circuit which includes a set of the battery module equivalent to that of FIG.8 and the one-battery-module filter block 501 being the anti-aliasing filter. The one-battery-module filter block 501 is only connected to the battery module E53. Accordingly, the one-battery-module-type battery unit 50 can be regarded as an independent circuit. The alternating-current voltage component Vo53 is described as follows;

$$Vo53 = Vi \, Z \, / \, (2R + Z)$$

Since the alternating-current voltage component Vo52 is equal to the alternating-current voltage component Vo54, the alternating-current voltage components Vo52 and Vo54 are respectively described as follows;

$$\{3 \, Vi \, Z \, / \, (2R + Z) - Vo53\} \, / \, 2$$

$$= Vo52 = Vo54 = Vi \, Z \, / \, (2R + Z)$$

Accordingly, each of five filters, corresponding to alternating-current voltage components Vo51 to Vo55, has an equivalent frequency response of the filter where one battery module is provided.

Viewed from another angle, the circuit of FIG. 18 is identical with the circuit of FIG.17 which includes the four sets of the battery modules and four filters when the resistor R43 (FIG. 17) connected to the center of the secondary battery 11 (FIG.7) is replaced with the one-battery module-type battery unit 50 (FIG.18). A circuit structure (FIG. 18) where blocks A and B are connected is identical with that of the four sets of the battery modules (FIG. 17).

As previously described above, in FIG. 17, the resistance value of the resistor R43 does not affect the frequency response of the filter. As described in this paragraph, when the resistor R43 is replaced with the independent circuit including the battery module and one filter, the frequency response of the other filters is not influenced.

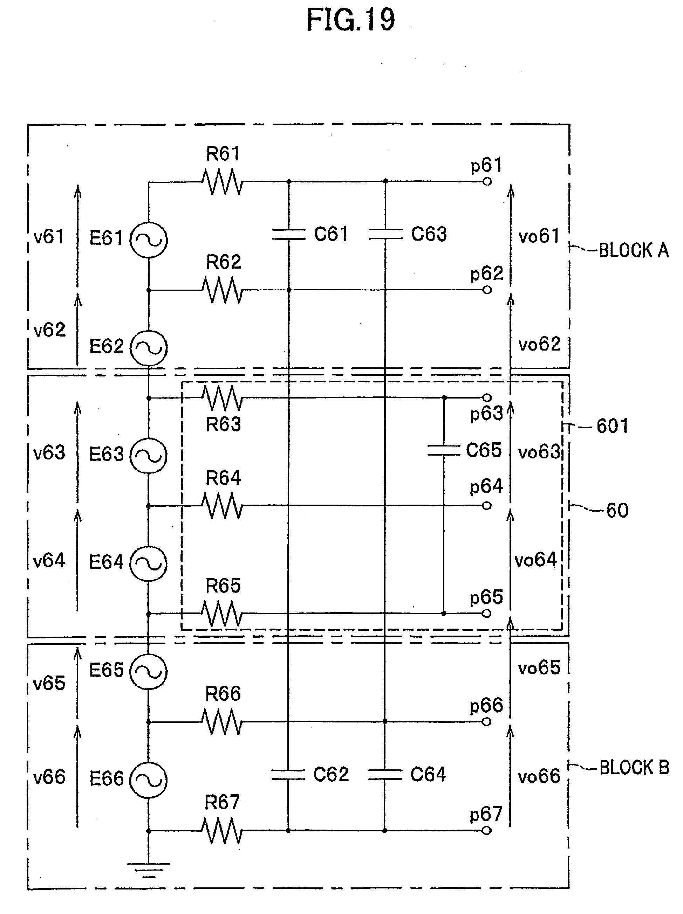

FIG. 19 shows the case where six battery modules are provided.

In FIG.19, a resistance value of resistors R61 to R67 is "R", a capacitance value of capacitors C61 to C65 is "C0", impedance of the capacitors C61 to C65 is "Z". Alternating-current voltage components V61 to V66 of battery modules E61 to E66 are equal to the voltage Vi (V61 = V62 = V63 = V64 =V65=V66=Vi).

As is the case where the three battery modules are provided, alternating-current voltage components Vo61, Vo62, Vo63, Vo64, Vo65 and Vo66 are described as follows;

$$Vo61 = Vi \, Z \, / \, (2R + Z)$$

The alternating-current voltage component Vo66 is equivalent to the alternating-current voltage component Vo61. Accordingly, the alternating-current voltage component Vo66 is described as follows;

$$Vo66 = Vi \, Z \, / \, (2R + Z)$$

When the voltages Vi of the battery modules E62, E63, E64, and E66 are added, the sum is four times as much as the voltage Vi. Accordingly, the sum is equal to the total voltage (Vo62 + Vo63 +Vo64 + Vo65) of the alternating-current voltage components Vo62, Vo63, Vo64, and Vo65.

Accordingly, the total voltage (Vo62+Vo63+Vo64+Vo65) is described as follows;

$$Vo62 + Vo63 + Vo64 + Vo65 = 4 \, Vi \, Z \, / \, (2R + Z)$$

On the other hand, a two-battery-module-type battery unit 60 is identical with a circuit which includes two sets of the battery modules shown in FIG.9 and the two-battery-module filter block 601 being the anti-aliasing filter. Accordingly, the two-battery-module-type battery unit 60 can be regarded as an independent circuit which can provide the alternating-current voltage components Vo63 and Vo64. The sum (Vo63+Vo64) of alternating-current voltage components Vo63 and Vo64 is described as follows;

$$Vo63 + Vo64 = 2\ Vi\ Z\ /\ (2R + Z)$$

As the alternating-current voltage component Vo63 is equal to the alternating-current voltage component Vo64, the alternating-current voltage component Vo63 is described as follows;

$$Vo63 = Vo64 = Vi\ Z\ /\ (2R + Z)$$

As the alternating-current voltage component Vo62 is equal to the alternating-current voltage component Vo65, the alternating-current voltage component Vo62 is described as follows;

$$\{4\ Vi\ Z\ /\ (2R + Z) - Vo63 - Vo64\}\ /\ 2$$

$$= Vo62 = Vo65 = Vi\ Z\ /\ (2R + Z)$$

Accordingly, each of six filters, corresponding to the alternating-current voltage components Vo61 to Vo66, has an equivalent frequency response of the filter where one battery module is provided.

Viewed from another angle, the circuit of FIG. 19 is identical with the circuit of FIG.17 which includes the four sets of the battery modules and four filters when the resistor R43 (FIG. 17) connected to the center of the secondary battery 11 is replaced with the two-battery module-type battery unit 60 (FIG. 18) including two sets of the battery modules and two-battery-module filter block 601.

As previously described, when the resistor R43 is replaced with the independent circuit including the battery module and two filters, the frequency response of the other filters is not influenced.

Since the resistance value of a resistor R43 does not affect the frequency response of the other filters, the resistor R43 can be of an arbitrary resistance value.

Next shows the case where seven battery modules are provided.

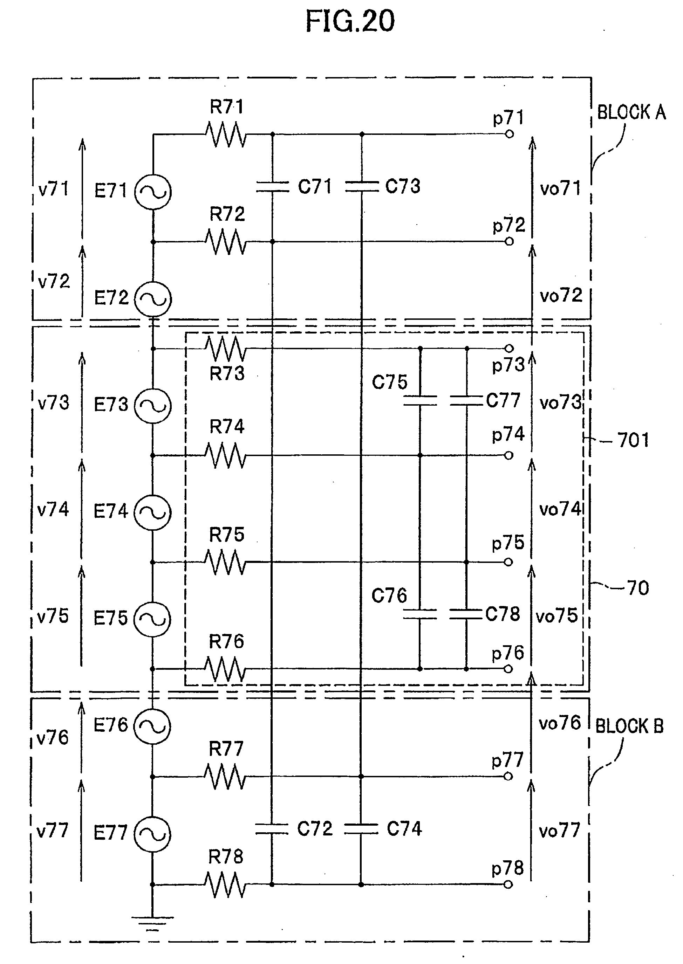

In FIG.20, a resistance value of resistors R71 to R78 is "R", a capacitance value of capacitors C71 to C78 is "C0", impedance of the capacitors C71 to C78 is "Z". Alternating-current voltage components V71 to V77 of battery modules E71 to E77 are equal to the voltage Vi (V71= V72 = V73 = V74 = V75 = V76 = V77 =Vi), so that alternating-current voltage components Vo71 to Vo77 can be determined.

A three-battery-module-type battery unit 70 which generates the alternating-current voltage components Vo73, Vo74, and Vo75 is identical with a circuit which includes three sets of the battery modules shown in FIG. 10. Accordingly, the three-battery-module-type battery unit 70 can be regarded as an independent circuit. As is the case where six sets of the battery modules are provided, the alternating-current voltage components Vo71, Vo72, Vo76, and Vo77 can be determined as follows;

$$Vo71 = Vo72 = Vo73 = Vo74 = Vo75 = Vo76 = Vo77$$

Since the equation above is equal to the equation (1), each of seven filters in FIG.20 has an equivalent frequency response of the filter where one battery module is provided.

Viewed from another angle, the circuit of FIG.20 is identical with the circuit of FIG.17 which includes the four sets of the battery modules and four filters when the resistor R43 (FIG. 17) connected to the center of the secondary battery 11 is replaced with the three-battery module-type battery unit 70 (FIG.20) including three sets of the battery modules and a three-battery-module filter block 701 being the anti-aliasing filter.

As previously described, when the resistor R43 is replaced with the independent circuit including the three battery modules and three filters, the frequency response of the other filters is not influenced.

Next shows the case where eight battery modules are provided.

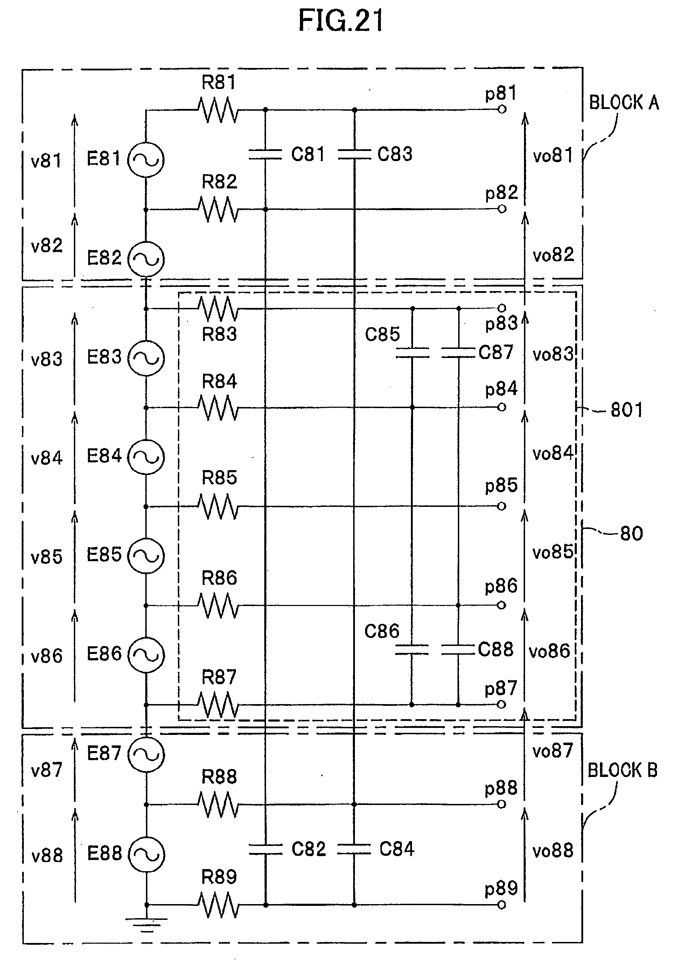

The circuit of FIG.21 is identical with the circuit of FIG.17 which includes the four sets of the battery modules and four filters when the resistor R43 (FIG. 17) connected to the center of the secondary battery 11 is replaced with an independent four-battery module-type battery unit 80 including four sets of the battery modules and a four-battery-module filter block 801 being the anti-aliasing filter.

As is the case where four sets of the battery modules are provided, alternating-current voltage components Vo81 to Vo88 can be determined as follows;

$$= \mathrm{Vi}\, Z\, /\, (2R + Z)$$

Each of eight filters in FIG.21 has an equivalent frequency response of the filter where one battery module is provided.

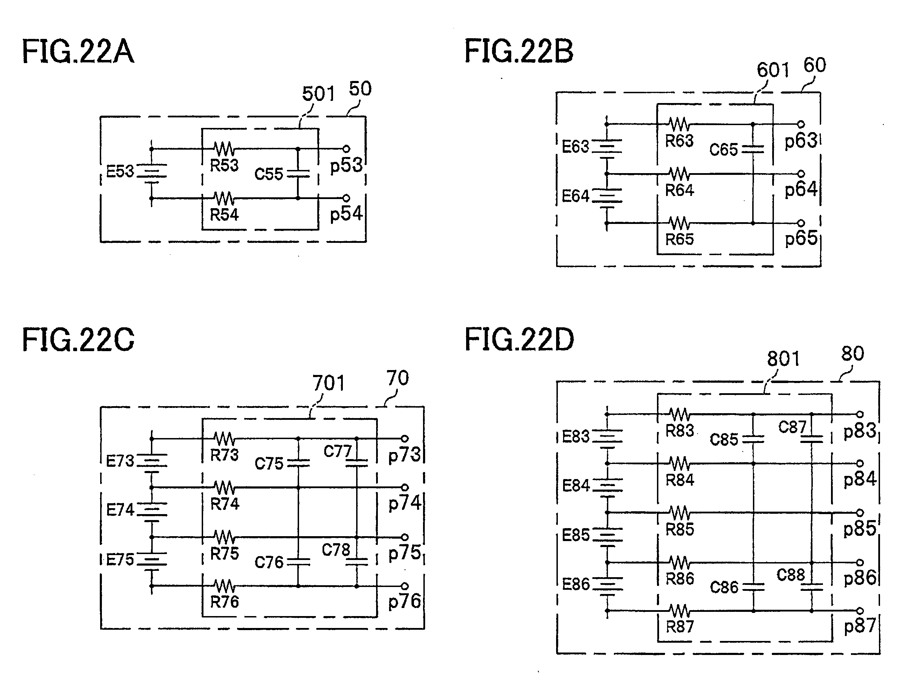

In the case where nine battery modules or more are provided, one-battery-module-type battery unit 50 of FIG.22A, two-battery-module-type battery unit 60 of FIG.22B, three-battery-module-type battery unit 70 of FIG.22C, four-battery-module-type battery-module 80 of FIG.22D are sequentially disposed in the position of the resistor R85 (at the fold-back point) shown in FIG.21. When the number M of battery modules is further increased, replacement will be described in the following. When the number M of battery modules is (4n +1), the one-battery-module-type battery unit 50 is disposed in the position of the resistor R85 of the four-battery-module-type battery-module 80 which is disposed at the center of the circuit. When the number M of battery modules is (4n +2), the two-battery-module-type battery unit 60 is disposed in the position of the resistor R85 of the four-battery-module-type battery-module 80. When the number M of battery modules is (4n +3), the three-battery-module-type battery unit 70 is disposed in the position of the resistor R85 of the four-battery-module-type battery-module 80. When the number M of battery modules is 4n, the four-battery-module-type battery unit 80 is disposed in the position of the resistor R85 of the four-battery-module-type battery-module 80.

As described above, the embodiment of the present invention can reduce the difference in frequency response of the battery module whose voltage is detected. When there is no difference in output voltage waveform of each battery module, there is no difference in voltage waveform through a filter. Consequently, the embodiment of the present invention can prevent the battery modules from erroneously being determined as if it were in an irregular condition. When a photo MOS relay is provided, a sampling frequency of switching is forced to be low due to a long delay in switching. However, since the embodiment of the present invention can reduce the difference in frequency responses, the anti-aliasing filter can provide relatively a high cut-off frequency. The voltage detecting device for battery modules includes a flying capacitor wherein a pair of the switches Sw1 and Sw2m and a pair of the switches Swd1 and Swd2 are alternately opened and closed, so that the secondary battery and the differential amplifier are insulated with each other.

[Comparative Example 1]

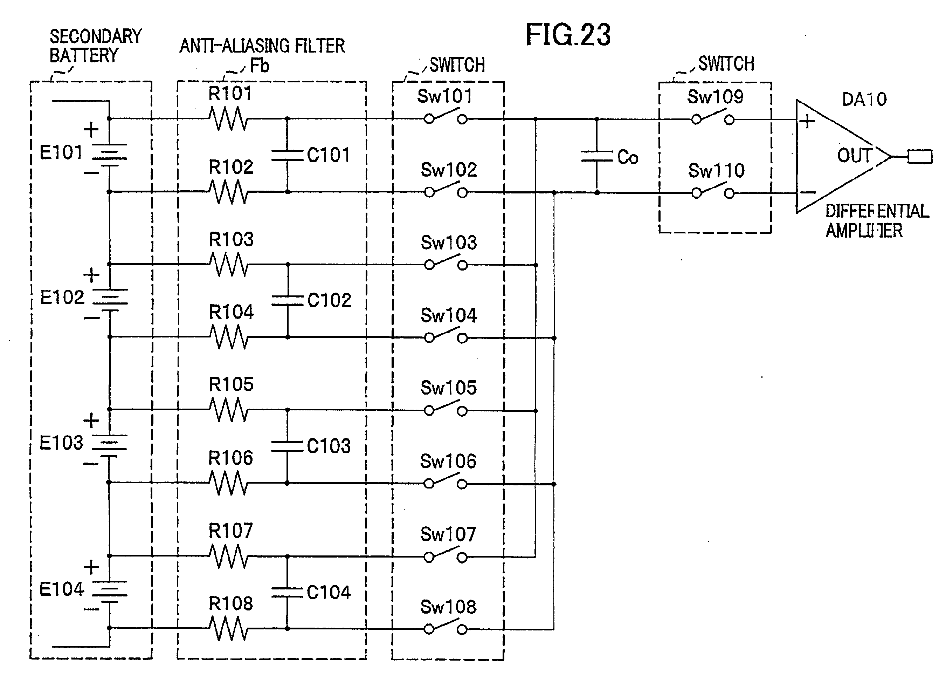

FIG.23 is a comparative example showing a voltage detecting device for battery modules wherein a flying capacitor topology is formed so as to measure the voltages of four battery modules.

In FIG.23, the secondary battery of the voltage detecting device is comprised of battery modules E101, E102, E103, and E104 in series. An anti-aliasing filter Fa is comprised of four low-pass filters. One low-pass filter includes two resistors R101 and R102 connected to both ends of the battery module E101, and a capacitor C101 connected to one end of the two resistors. Each of the other three low-pass filters also includes two resistors and a capacitor, corresponding to respective battery modules E102 to E104. The resistors R101 to R108 are of equal resistance value, and the capacitors C101 to C104 are of equal capacitance.

As shown in the circuit of the voltage detecting device of FIG.7, there is one connecting point between the battery modules, each of the connecting points is connected to one resistor. On the other hand, as shown in the circuit of the voltage detecting device of FIG.23, there are two connecting points between the battery modules, each of the two connecting points is connected to one resistor.

[Comparative Example 2]

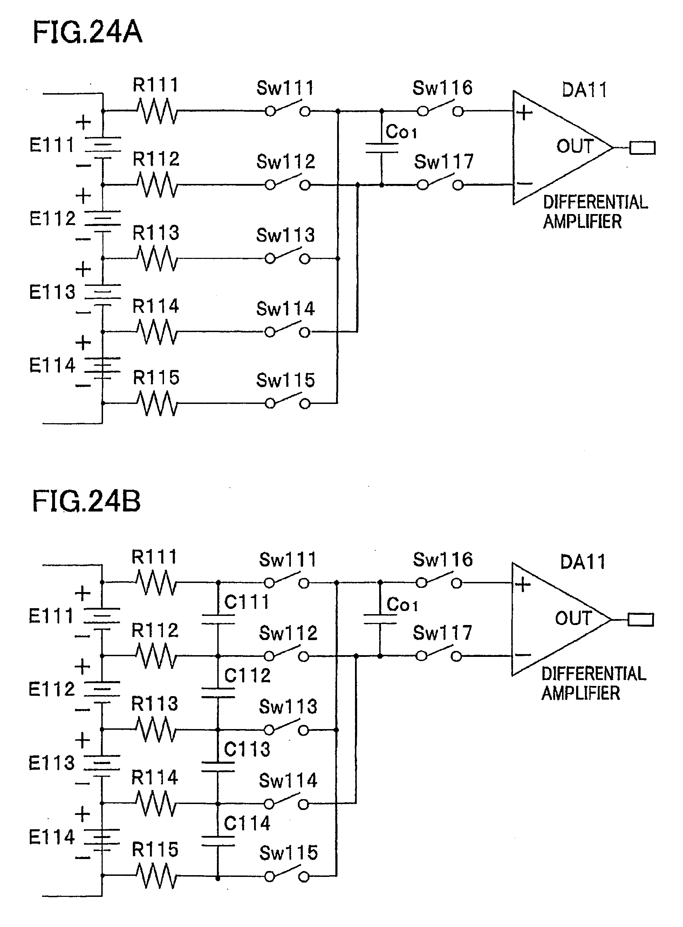

Since the switches are relatively expensive, a voltage detecting circuit in which the number of the switches is reduced can be provided as shown in FIG.24.

As compared with FIG.23, in FIG.24A, the number of switches is reduced to approximately the half. As shown in FIG.34B, when capacitors C111 to C114 having equal capacitance are added to the circuit of FIG.24A to form an anti-aliasing filter, the circuit of FIG.24B is different from the circuit of FIG.23 of the comparative example 1. When the alternating-current voltage component of each battery module is measured, one element is reciprocally affected with another element, so that the difference in frequency response of each anti-aliasing filter appears.

The case where one battery module is provided is exemplified so as to examine the frequency response of the anti-aliasing filter. Back to FIG.8, the circuit of FIG.8 is a first anti-aliasing filter including one battery module E1, two resistors R11 and R12 having an equal resistance value, and the capacitor C11.

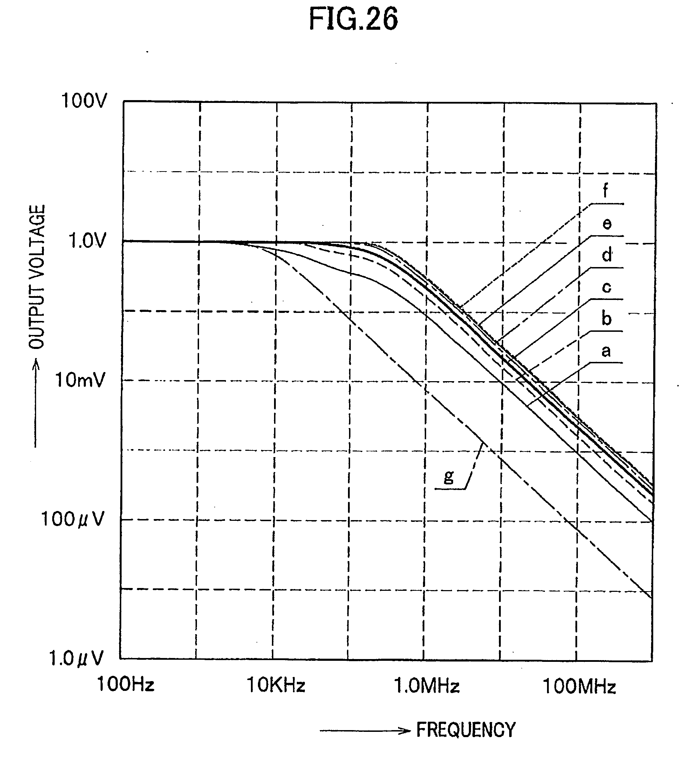

In this circuit where direct-current electromotive force of the battery module E11 is 0 V, alternating-current electromotive force the battery module E11 is 1 V, the resistance value of the resistor R11 and R12 is 100 $\Omega$ (ohm), and the capacitance of the capacitor C11 is 0.1 $\mu$F, the value of a measured voltage (output voltage) across the capacitor C11 corresponding to each alternating-current frequency is shown in the characteristic curve G of the anti-aliasing filter in FIG.26.

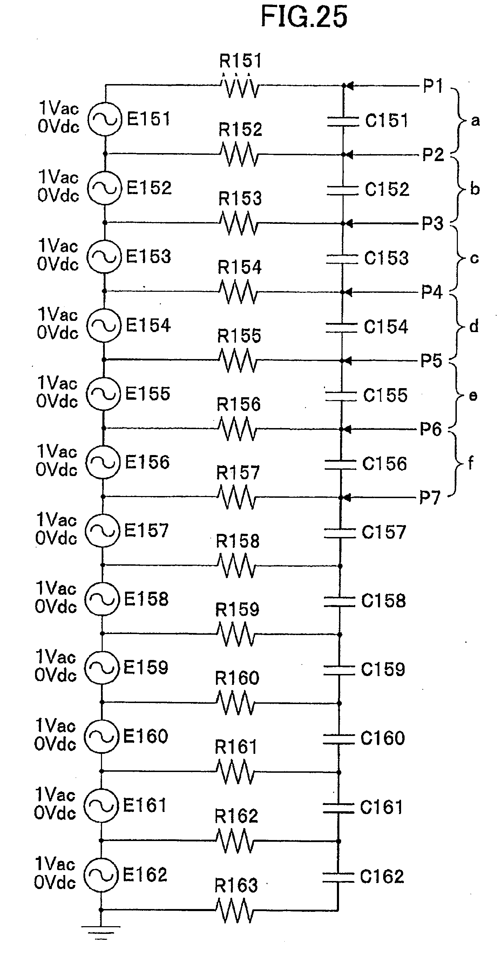

FIG.25 shows a voltage detecting circuit for battery modules wherein a plurality (twelve) of battery modules E151 to E162 are connected in series.

As is the case where one battery module is provided in FIG.8, FIG.25 shows an anti-aliasing filter which includes resistors R151 to R163 having an equal resistance value and capacitors C151 to C162 having equal capacitance.

As is the case where one battery module is provided, direct-current electromotive force of battery modules E151 to E162 is 0 V, alternating-current electromotive force of the battery modules E151 to E162 is 1 V, resistance value of resistors R151 to R163 is 100 $\Omega$ (ohm), and capacitance of capacitors C151 to C162 is 0.1 $\mu$F.

In this case, FIGs.26 shows the frequency characteristic curves of the anti-aliasing filters on the basis of the value of a measured voltage (output voltage) across the capacitors C151 to C162 corresponding to a frequency. For example, a solid line A in FIG.26 shows the frequency characteristic curve corresponding to the voltage across the capacitor C151. A positive electrode of the capacitor C151 at a point P1 and a negative electrode of the capacitor C151 at a point P2 are respectively measured. A dotted line B in FIG.26B shows the frequency characteristic curve corresponding to the voltage across the capacitor C152 whose positive electrode at the point P2 and negative electrode at the point P3 are measured. As is the case with the capacitors C151 and C152, a solid line C in FIG.26 shows the frequency characteristic curve of the voltage across the capacitor C153, a chain line D in FIG.26 shows the frequency characteristic curve of the voltage across the capacitor C154, a chain line E in FIG.26 shows the frequency characteristic curve of the voltage across the capacitor C155, and a dotted line in FIG.26 shows the frequency characteristic curve of the voltage across the capacitor C156.

As shown in the frequency characteristic curves of the lines A to F of FIG.26, when the anti-aliasing filters constituted in a ladder type are applied to a plurality of battery modules E151 to E162, and each rated value of elements of the anti-aliasing filters is equal to the rated value of the elements of one filter where one battery module is provided, the cut-off frequency of the anti-aliasing filters rises to a large extent. The closer the anti-aliasing filter comes to the center of the circuit which includes battery modules connected in series and the capacitors, the higher the cut-off frequency becomes. Consequently, the cut-off frequency characteristic of the anti-aliasing filter becomes inhomogeneous.

The embodiment shown in FIG. 7 can solve the problem and reduce the difference in frequency response of the anti-aliasing filter.

[Modified Example]

The embodiments of the present invention is not limited, but can be modified as described below.

In the embodiments described above, the anti-aliasing filter is constituted of a low-pass filter having the resistor and the capacitor. However, the anti-aliasing filter can be constituted of the capacitor and a coil, instead of the resistor.

The resistor can be replaced with a capacitor and a plurality of switches which constitute a switched capacitor topology.

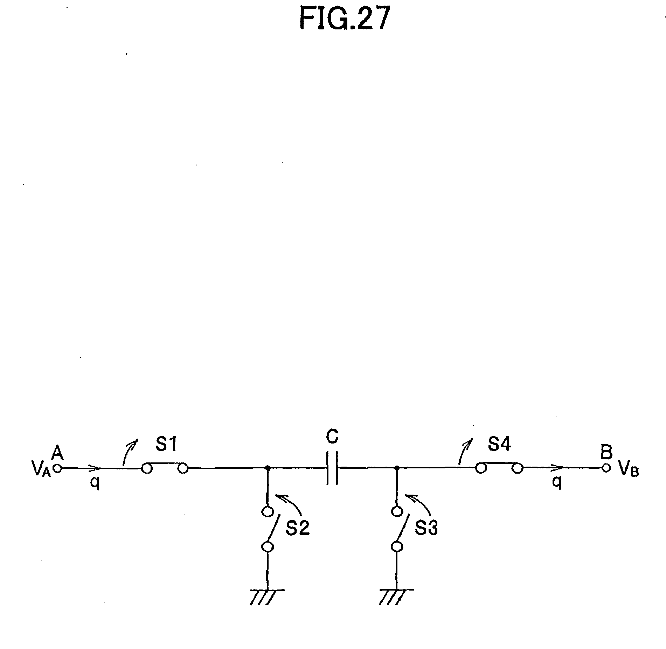

For example, FIG.27 shows a switched capacitor circuit in which a capacitor C is disposed between points A and B, both ends of the capacitor C are connected to switches S1 and S4, a connecting point between the capacitor C and the switch S1 is connected to a switch S2 which is grounded, and a connecting point between the capacitor C and the switch S4 is connected to a switch S3 which is grounded.

In this time, a pair of switches S1 and S4 and a pair of switches S2 and S3 are alternately opened and closed at a sampling time interval T, so that a charge Q of the capacitor C flows between the points A and B.

In the case where the capacitor is repeatedly charged and discharged, an electric potential of the point A is "Va" and an electric potential of the point B is "Vb", and the capacitance of the capacitor C is "C0", an average current Iav flown between the points A and B is described as follows;

$$\mathrm{Iav} = Q \; / \; T = (C0 \; / \; T) \, (Va - Vb) = (Va - Vb) \; / \; R$$

Accordingly, the switched capacitor circuit of FIG.27 becomes equivalent to a resistor having the resistance value R (R = T / C0).

The switching circuits shown in FIGs.1 and 7 are constituted by an analog multiplexer and can be integrally or separately constituted with the voltage detecting circuit DA1. In the case where the switching circuit is integrally constituted with the voltage detecting circuit DA1, the capacitor C01 and the switches Swd1 and Swd2 (FIGs.1 and 7) are not provided, and an output voltage of the switches Swm1 to Swm(m+1) is directly detected.

## Claims

1. A voltage detecting device for battery modules for individually detecting a voltage of a battery module of a secondary battery (11), wherein each battery module is constituted of at least one cell or more, and M sets of battery modules are connected in series, and "M" is a positive integer, the voltage detecting device for battery modules comprising:

(M+1) sets of voltage detecting terminals for being connected to a positive electrode of a top battery module, a negative electrode of an end battery module, and (M-1) sets of connecting points between the battery modules; a filtering circuit whose input terminals are connected to the voltage detecting terminals; a switching circuit (14) whose input terminals are connected to output terminals of the filter circuit; and a voltage detecting circuit for being connected to output terminals of the switching circuit (14) and detecting the voltage of each battery module, wherein the filter circuit (12) includes resistors (R11, R12) disposed between the input terminals and the output terminal of the filter circuit, and a capacitor disposed between the terminals of the resistors (R11, R12), whereby obtaining a characteristic of a low-pass filter, and

wherein an integer N is a positive integer and wherein M is at least one of 4n, 4n+1, 4n+2, and 4n+3, being a positive integer the resistor/capacitor configuration is made up of (M+1) sets of said resistors (R11, R12) having an equal resistance value to connect an N-th input terminal of the filter circuit (12) to an N-th output terminal of the filter circuit, and M sets of said capacitors whose terminals are connected between the output terminals of two adjacent resistors (R11, R12) out of the (M+1) sets of resistors (R11, R12), and wherein when capacitance of the capacitor corresponding to a first battery module is regarded as 1, capacitance ratio of the capacitor corresponding to an N-th battery module is expressed as "N(M-N+1)/M".

2. The voltage detecting device for battery modules according to any of the preceding claims, wherein "M" is a positive integer, and a resistor connected between M/2-th input terminal of the filter circuit (12) and M/2-th output terminal of the filter circuit (12) is replaced with a wire.

3. The voltage detecting device for battery modules according to any of the preceding claims, wherein when the number of battery module is expressed as "M" being a positive and integer, a resistor connected between M/2-th input terminal of the filter circuit (12) and M/2-th output terminal of the filter circuit (12) is replaced with a wire.

4. The voltage detecting device for battery modules according to any of the preceding claims, wherein the resistor is provided as a dummy load by a switching capacitor (Co1) method of providing the capacitor (Co1) and a plurality of switches.

5. The voltage detecting device for battery modules according to any of the preceding claims, wherein the switching circuit (14) is an analog multiplexer integrally or separately constituted with the voltage detecting circuit.

## Patentansprüche

1. Spannungserkennungsvorrichtung für Batteriemodule zur individuellen Erkennung einer Spannung eines Batteriemoduls einer Sekundärbatterie (11), wobei jedes Batteriemodul aus mindestens einer Zelle oder mehr besteht und M Sätze von Batteriemodulen in Reihe geschaltet sind, und "M" eine positive ganze Zahl ist, wobei die Spannungserkennungsvorrichtung für Batteriemodule Folgendes aufweist:

(M+1) Sätze von Spannungserkennungsanschlüssen zum Anschluss an eine positive Elektrode eines oberen Batteriemoduls, eine negative Elektrode eines unteren Batteriemoduls, und (M-1) Sätze von Anschlussstellen zwischen den Batteriemodulen; einen Filterkreis, dessen Eingangsanschlüsse mit den Spannungserkennungsanschlüssen verbunden sind; einen Schaltkreis (14), dessen Eingangsanschlüsse mit Ausgangsanschlüssen des Filterkreises verbunden sind; sowie

einen Spannungserkennungskreis zum Anschluss an Ausgangsanschlüsse des Schaltkreises (14) und Erkennen der Spannung jedes Batteriemoduls,

wobei

der Filterkreis (12) Widerstände (R11, R12), die zwischen den Eingangsanschlüssen und den Ausgangsanschlüssen des Filterkreises angeordnet sind, und einen Kondensator aufweist, der zwischen den Anschlüssen der Widerstände (R11, R12) angeordnet ist, wodurch eine Kenngröße eines Tiefpassfilters erhalten wird, und

wobei eine ganze Zahl N eine positive ganze Zahl ist, und

wobei M mindestens eine von 4n, 4n+1, 4n+2 und 4n+3 ist, und eine positive ganze Zahl ist,

die Widerstands-/Kondensatorkonfiguration aus (M+1) Sätzen der Widerstände (R11, R12), die einen gleichen Widerstandswert aufweisen, um einen N-ten Eingangsanschluss des Filterkreises (12) an einen N-ten Ausgangsanschluss des Filterkreises anzuschließen, und M Sätzen der Kondensatoren aufgebaut ist, deren Anschlüsse zwischen den Ausgangsanschlüssen von zwei benachbarten Widerständen (R11, R12) aus den (M+1) Sätzen von Widerständen (R11, R12) angeschlossen sind, und

wobei, wenn die Kapazität des einem ersten Batteriemodul entsprechenden Kondensators als 1 betrachtet wird, das Kapazitätsverhältnis des einem N-ten Batteriemodul entsprechenden Kondensators als "N(M-N+1)/M" ausgedrückt wird.

2. Spannungserkennungsvorrichtung für Batteriemodule gemäß einem der vorhergehenden Ansprüche, wobei "M" eine positive ganze Zahl ist und ein zwischen dem M/2-ten Eingangsanschluss des Filterkreises (12) und dem M/2-ten Ausgangsanschluss des Filterkreises (12) angeschlossener Widerstand durch einen Draht ersetzt ist.

3. Spannungserkennungsvorrichtung für Batteriemodule gemäß einem der vorhergehenden Ansprüche, wobei, wenn die Anzahl an Batteriemodulen als "M" ausgedrückt wird und M eine positive und ganze Zahl ist, ein zwischen den M/2-ten Eingangsanschluss des Filterkreises (12) und den M/2-ten Ausgangsanschluss des Filterkreises (12) angeschlossener Widerstand durch einen Draht ersetzt ist.

4. Spannungserkennungsvorrichtung für Batteriemodule gemäß einem der vorhergehenden Ansprüche, wobei der Widerstand als eine Blindlast durch ein Schaltkondensator (Co1) Verfahren vorgesehen ist, das den Kondensator (Co1) und mehrere Schalter bereitstellt.

5. Spannungserkennungsvorrichtung für Batteriemodule gemäß einem der vorhergehenden Ansprüche, wobei der Schaltkreis (14) aus einem Analogmultiplexer besteht, der einstückig oder separat mit der Spannungserkennungsschaltung gebildet ist.

**Revendications**

1. Dispositif de détection de tension pour modules de batterie pour détecter individuellement une tension d'un module de batterie secondaire (11), dans lequel chaque module de batterie secondaire est constitué d'au moins une cellule ou plus, et M ensembles de modules de batterie sont raccordés en séries, et « M » est un nombre entier positif, le dispositif de détection de tension pour des modules de batterie comprenant :

(M+1) ensembles de bornes de détection de tension pour être raccordés à une électrode positive d'un module de batterie supérieur, une électrode négative d'un module de batterie d'extrémité, et (M-1) ensembles de points de raccordement entre les modules de batterie ;

un circuit de filtrage dont les bornes d'entrée sont raccordées aux bornes de détection de tension ;

un circuit de commutation (14) dont les bornes d'entrée sont raccordées à des bornes de sortie du circuit filtre ; et

un circuit de détection de tension pour être raccordé aux bornes de sortie du circuit de commutation (14) et détectant la tension de chaque module de batterie,

dans lequel

le circuit filtre (12) comprend

des résistances (R11, R12) disposées entre les bornes d'entrée et la borne de sortie du circuit filtre, et un condensateur disposé entre les bornes des résistances (R11, R12), obtenant ainsi une caractéristique d'un filtre passe-bas, et

dans lequel un nombre entier N est un nombre entier positif, et

dans lequel M est au moins un de 4n, 4n+1, 4n+2, et 4n+3, n étant un nombre entier positif,

la configuration résistance / condensateur est composée de (M+1) ensembles desdites résistances (R11, R12) ayant une valeur de résistance égale pour raccorder une Nième borne d'entrée du circuit filtre (12) à une Nième borne de sortie du circuit filtre, et M ensembles desdits condensateurs dont les bornes sont raccordées entre les bornes de sortie de deux résistances adjacentes (R11, R12) des (M+1) ensembles de résistances (R11, R12), et dans lequel lorsque la capacité du condensateur correspondant à un premier module de batterie est considérée comme 1, le rapport de capacité du condensateur correspondant à un Nième module de batterie est exprimé comme « N(M-N+1)/M ».

2. Dispositif de détection de tension pour des modules de batterie selon l'une quelconque des revendications précédentes, dans lequel « M » est un nombre entier positif, et une résistance raccordée entre la M/2-ième borne d'entrée du circuit filtre (12) et la M/2-ième borne de sortie du circuit filtre (12) est remplacée par un fil.

3. Dispositif de détection de tension pour des modules de batterie selon l'une quelconque des revendications précédentes, dans lequel lorsque le nombre de modules de batterie est exprimé par « M » qui est un nombre entier positif, une résistance raccordée entre la M/2-ième borne d'entrée du circuit filtre (12) et la M/2-ième borne de sortie du circuit filtre (12) est remplacée par un fil.

4. Dispositif de détection de tension pour des modules de batterie selon l'une quelconque des revendications précédentes, dans lequel la résistance est prévue comme une charge fictive par un condensateur de commutation (Co1), procédé de fourniture du condensateur (Co1) et une pluralité de commutateurs.

5. Dispositif de détection de tension pour des modules de batterie selon l'une quelconque des revendications précédentes, dans lequel le circuit de commutation (14) est un multiplexeur analogique constitué intégralement ou séparément avec le circuit de détection de la tension.

FIG.1

# FIG.2

# FIG.3A

# FIG.3B

# FIG.3C

# FIG.4A

# FIG.4B

# FIG.4C

FIG.5A FIG.5B FIG.5C

# FIG.6

BATTERY MODULE NUMBER

| | 2 | 3 | 4 | 5 | 6 | 7 | 8 | 9 | 10 | 11 | 12 | | m |
|---|---|---|---|---|---|---|---|---|---|---|---|---|---|
| FIRST BATTERY MODULE | 2 | 3 | 4 | 5 | 6 | 7 | 8 | 9 | 10 | 11 | 12 | | $m$ |
| SECOND BATTERY MODULE | 2 | 4 | 6 | 8 | 10 | 12 | 14 | 16 | 18 | 20 | 22 | | $2(m-1)$ |
| THIRD BATTERY MODULE | | 3 | 6 | 9 | 12 | 15 | 18 | 21 | 24 | 27 | 30 | | $3(m-2)$ |
| FOURTH BATTERY MODULE | | | 4 | 8 | 12 | 16 | 20 | 24 | 28 | 32 | 36 | | $4(m-3)$ |
| FIFTH BATTERY MODULE | | | | 5 | 10 | 15 | 20 | 25 | 30 | 35 | 40 | | $5(m-4)$ |
| SIXTH BATTERY MODULE | | | | | 6 | 12 | 18 | 24 | 30 | 36 | 42 | | $6(m-5)$ |
| SEVENTH BATTERY MODULE | | | | | | 7 | 14 | 21 | 28 | 35 | 42 | | $7(m-6)$ |
| EIGHTH BATTERY MODULE | | | | | | | 8 | 16 | 24 | 32 | 40 | | $8(m-7)$ |
| NINTH BATTERY MODULE | | | | | | | | 9 | 18 | 27 | 36 | | $9(m-8)$ |
| TENTH BATTERY MODULE | | | | | | | | | 10 | 20 | 30 | | $10(m-9)$ |
| ELEVENTH BATTERY MODULE | | | | | | | | | | 11 | 22 | | $11(m-10)$ |
| TWELFTH BATTERY MODULE | | | | | | | | | | | 12 | | $12(m-11)$ |

CAPACITANCE

# FIG.7

# FIG.8

## FIG.9A

## FIG.9B

# FIG.10

**FIG.11A**

**FIG.11B**

**FIG.11C**

FIG.12A

FIG.12B

FIG.12C

FIG.12D

EP 2 063 279 B1

FIG.13

## FIG.14A

## FIG.14B

FIG.15B

FIG.15A

FIG.16B

FIG.16A

# FIG.17

# FIG.18

# FIG.19

# FIG.20

# FIG.21

EP 2 063 279 B1

FIG.22A

FIG.22B

FIG.22C

FIG.22D

44

# FIG.23

SECONDARY
BATTERY

ANTI-ALIASING FILTER
Fb

SWITCH

SWITCH

DA10

Sw101

R101

Sw109

E101

C101

Sw102

R102

Sw110

OUT

Co

DIFFERENTIAL
AMPLIFIER

R103

Sw103

E102

C102

R104

Sw104

R105

Sw105

E103

C103

R106

Sw106

R107

Sw107

E104

C104

R108

Sw108

EP 2 063 279 B1

# FIG.24A

# FIG.24B

# FIG.25

# FIG.26

# FIG.27

**EP 2 063 279 B1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2005003618 A
- US 6803766 B